(19) Europäisches Patentamt / European Patent Office / Office européen des brevets

(11) **EP 4 455 859 A1**

(12) **EUROPEAN PATENT APPLICATION**

(43) Date of publication:
**30.10.2024 Bulletin 2024/44**

(21) Application number: **24164815.3**

(22) Date of filing: **20.03.2024**

(51) International Patent Classification (IPC):
**G06F 7/533** (2006.01)      **G06F 7/544** (2006.01)

(52) Cooperative Patent Classification (CPC):
**G06F 7/5332; G06F 7/5443**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **27.04.2023  CN 202310468468**
**28.06.2023  CN 202310778309**

(71) Applicant: **Beijing Horizon Information Technology Co., Ltd.**
**Beijing 100094 (CN)**

(72) Inventors:
• **DING, Jinnan**
  **Beijing, 100094 (CN)**
• **WU, Xiangtao**
  **Beijing, 100094 (CN)**

(74) Representative: **Dehns Germany Partnerschaft mbB**
**Theresienstraße 6-8**
**80333 München (DE)**

(54) **OPERATION METHOD OF MULTIPLIER, OPERATION APPARATUS, ELECTRONIC DEVICE, AND STORAGE MEDIUM**

(57)    Disclosed are an operation method of multiplier, operation apparatus, electronic device, and storage medium. The method includes: determining a plurality of input data sets of the multiplier and an encoding manner for the multiplier; determining at least one low-order input data set in the plurality of input data sets; determining a carry compensation term corresponding to the at least one low-order input data set based on the at least one low-order input data set and the encoding manner; de-termining a target partial product array based on the carry compensation term corresponding to the at least one low-order input data set and the plurality of input data sets; and determining a product operation result for each input data set based on the target partial product array. According to this disclosure, multiplication operations with multiple precision may be implemented by using one multiplier, thereby reducing hardware resource consumption and hardware area.

FIG.1

**Description**

**CROSS REFERENCE**

This application claims priority to Chinese patent application No. 202310468468.2, filed on April 27, 2023.

**FIELD OF THE INVENTION**

This disclosure relates to the technical field of data processing, and in particular, to an operation method of multiplier, an operation apparatus, an electronic device, and a storage medium.

**BACKGROUND OF THE INVENTION**

In a microprocessor chip, a multiplier is a core for digital signal processing. Speed and area optimization for the multiplier are crucial for overall performance of the microprocessor. In addition, diversity of computation accuracy of the multiplier determines a range of algorithms that can be processed by the microprocessor. Therefore, the diversity of the computation accuracy of the multiplier is also important for the performance of the microprocessor.

**SUMMARY OF THE INVENTION**

Typically, a multiplier is configured to calculate a multiplication operation with one precision. It is proposed in relevant schemes to combine a plurality of multipliers to implement multiplication operations with other precision besides this precision, so as to implement multiplication operations with multiple precision. However, combining a plurality of multipliers poses problems of great hardware resource consumption and significant area overhead.

To resolve the foregoing technical problems, this disclosure is proposed. Embodiments of this disclosure provide an operation method of multiplier, an operation apparatus of multiplier, an electronic device, and a storage medium, which may implement multiplication operations with multiple precision and reduce hardware resource consumption and hardware area.

According to a first aspect of this disclosure, an operation method of multiplier is provided. The method includes: first, determining a plurality of input data sets of the multiplier and an encoding manner for the multiplier; subsequently, determining at least one low-order input data set in the plurality of input data sets; then, determining a carry compensation term corresponding to the at least one low-order input data set based on the at least one low-order input data set and the encoding manner; further, determining a target partial product array based on the carry compensation term corresponding to the at least one low-order input data set and the plurality of input data sets; and finally, determining a product operation result for each input data set based on the target partial product array.

According to a second aspect of this disclosure, an operation apparatus is provided, including: a compensation determining module, a partial product array determining module, and a partial product processing module. The compensation determining module is configured to: determine a plurality of input data sets of a multiplier and an encoding manner for the multiplier; determine at least one low-order input data set in the plurality of input data sets; and determine a carry compensation term corresponding to the at least one low-order input data set based on the at least one low-order input data set and the encoding manner.

The partial product array determining module is configured to determine a target partial product array based on the carry compensation term corresponding to the at least one low-order input data set that is determined by the compensation determining module and the plurality of input data sets. The partial product processing module is configured to determine a product operation result for each input data set based on the target partial product array determined by the partial product array determining module.

According to a third aspect of this disclosure, a computer readable storage medium is provided. The storage medium stores a computer program, and the computer program is used for implementing the operation method of multiplier provided in the first aspect.

According to a fourth aspect of this disclosure, an electronic device is provided. The electronic device includes: a processor; and a memory configured to store processor-executable instructions, wherein the processor is configured to read the executable instructions from the memory, and execute the instruction to implement the operation method of multiplier provided in the first aspect.

According to a fifth aspect of this disclosure, a computer program product is provided. When instructions in the computer program product are executed by a processor, the operation method of multiplier provided in the first aspect is implemented.

Based on the operation method of multiplier and the operation apparatus, the electronic device, and the storage medium that are provided in this disclosure, if the carry compensation term corresponding to the at least one low-order input data set is added into the target partial product array (PPA), it may be learned that the target PPA includes not only a sub PPA corresponding to each low-order input data set, but also the carry compensation term corresponding to each low-order input data set. In this way, during an accumulation process of the target PPA, the carry compensation term corresponding to each low-order input data set in the target PPA may cancel out a carry during accumulation of the sub PPA corresponding to the low-order input data set, so that the carry during the accumulation of the sub PPA corresponding to each low-order input data set would not affect a product operation result of a high-order input data set corresponding to each low-order input data set. As a result, accuracy of the product operation result of the high-order input data set corresponding to each low-order input data set in the plurality of input data sets is ensured. In addition, the product operation result of the at least one low-order input data set in the plurality of input data sets is also accurate. In view of the above, the product operation result of each input data set is accurate, and thus multiplication operations with multiple precision may be implemented. Moreover, the operation method of multiplier provided in this disclosure does not require combination of a plurality of multipliers. Multiplication operations with multiple precision may be implemented by using one multiplier, thereby reducing hardware resource consumption and hardware area.

## BRIEF DESCRIPTION OF THE DRAWINGS

FIG. 1 is a schematic flowchart 1 of an operation method of multiplier according to this disclosure;
FIG. 2 is a schematic diagram of a target PPA corresponding to one input data set according to this disclosure;
FIG. 3 is a schematic diagram of a target PPA corresponding to a plurality of input data sets according to this disclosure;
FIG. 4 is a schematic flowchart 2 of an operation method of multiplier according to this disclosure;
FIG. 5 is a schematic flowchart 3 of an operation method of multiplier according to this disclosure;
FIG. 6 is a schematic flowchart 4 of an operation method of multiplier according to this disclosure;
FIG. 7 is a schematic flowchart 5 of an operation method of multiplier according to this disclosure;
FIG. 8 is a diagram 1 of a structure of an electronic device according to this disclosure;
FIG. 9 is a schematic diagram of another target PPA corresponding to a plurality of input data sets according to this disclosure;
FIG. 10 is a schematic flowchart of implementing an operation method of multiplier for a plurality of input data sets according to this disclosure;
FIG. 11 is another schematic flowchart of implementing an operation method of multiplier for a plurality of input data sets according to this disclosure;
FIG. 12 is a diagram 1 of a structure of an operation apparatus according to this disclosure;
FIG. 13 is a diagram 2 of a structure of an operation apparatus according to this disclosure; and
FIG. 14 is a diagram 2 of a structure of an electronic device according to an embodiment of this disclosure.

## DETAILED DESCRIPTION OF THE EMBODIMENTS

To explain this disclosure, exemplary embodiments of this disclosure are described below in detail with reference to accompanying drawings. Obviously, the described embodiments are merely a part, rather than all of embodiments of this disclosure. It should be understood that this disclosure is not limited by the exemplary embodiments.

It should be noted that unless otherwise specified, the scope of the present disclosure is not limited by relative arrangement, numeric expressions, and numerical values of components and steps described in these embodiments.

Hereinafter, terms "first" and "second" are merely intended for a purpose of description, and shall not be understood as an indication or implication of relative importance or implicit indication of the quantity of indicated technical features. Therefore, a feature limited by "first" or "second" may explicitly or implicitly include at least one or more features. In the description of this disclosure, unless otherwise stated, "a plurality of" means two or more than two. "A and/or B" include the following three combinations: A alone, B alone, and both A and B.

Application overview

To implement multiplication operations with multiple precision, in relevant schemes, in addition to performing a low-precision multiplication operation by using one multiplier, a high-precision multiplication operation is also performed by combining a plurality of multipliers. Specifically, it is proposed in the relevant schemes to split each of two pieces of high-precision data into low-bit data and high-bit data. Further, a plurality of multipliers supporting low-precision multiplication operations are used to respectively calculate a product operation result of the two pieces of low-bit data, a product operation result of the low-bit data and the high-bit data, and a product operation result of the two pieces of high-bit data. Subsequently, the product operation results of the plurality of multipliers are accumulated by weight to obtain a high-precision product operation result of two pieces of data. Low-precision and high-precision multiplication operations are implemented by using low-precision multipliers.

For example, a multiplicand A and a multiplicator B of int16 are used as examples, where $A=a_{15} a_{14}...a_1a_0$, and the multiplicator $B=b_{15} b_{14}...b_1b_0$. In the relevant schemes, the multiplicand A is split into two pieces of int8 data, that is, $A_H$ and $A_L$; and the multiplicator B is also split into two pieces of int8 data, that is, $B_H$ and $B_L$. $A = A_H * 2^8 + A_L$, where $A_H=a_{15}a_{14}...a_9a_8$, and $A_L=a_7a_6...a_1a_0$. $B = B_H * 2^8 + B_L$, where $B_H=b_{15}b_{14}...b_9b_8$, and $B_L=b_7b_6...b_1b_0$. Subsequently, according to the relevant schemes, four multipliers that support int8 may be used to calculate a product operation result of $A_H$ and $B_H$, a product operation result of $A_L$ and $B_H$, a product operation result of $A_L$ and $B_H$, and a product operation result of $A_L$ and $B_L$, respectively. Subsequently, the four product operation results are accumulated by weight to obtain a product operation result of the multiplicand A and the multiplicator B. The product operation result of the multiplicand A and the multiplicator B is shown in the following equation (1).

$$A * B = A_H * B_H * 2^{16} + (A_H * B_L + A_L * B_H) * 2^8 + A_L * B_L \quad (1)$$

It may be understood that in the relevant schemes, four int8 multipliers are combined to implement a multiplication operation of int16.

According to the foregoing relevant schemes, although multiplication operations with multiple precision such as low precision and high precision may be implemented, a plurality of low-precision multipliers need to be combined to implement a high-precision multiplication element. The use of a plurality of multipliers poses problems of hardware resource wastes and significant area overhead.

Exemplary system

The operation method of multiplier provided in embodiments of this disclosure is widely applied in a plurality of scenarios, such as real-time image processing and digital signal processing.

The operation method of multiplier provided in the embodiments of this disclosure may be implemented by an electronic device or by an operation apparatus. The operation apparatus may be located in the electronic device, being a part (such as a CPU, a microprocessor chip, or a multiplier) of the electronic device.

Exemplary method

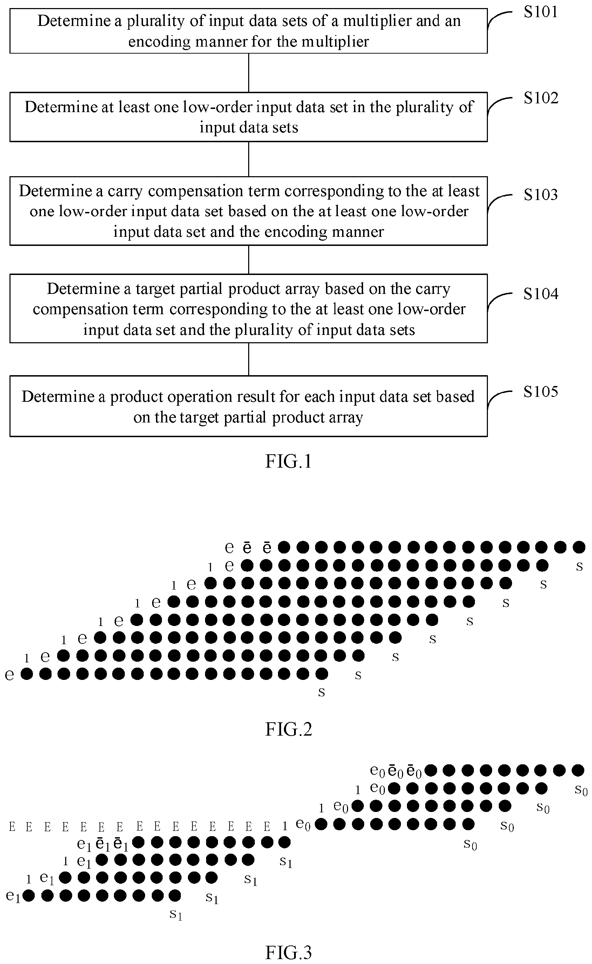

FIG. 1 is a schematic flowchart of an operation method of multiplier according to an exemplary embodiment of this disclosure. The operation method of multiplier provided in this embodiment may be applied to an electronic device. As shown in FIG. 1, the operation method of multiplier may include the following steps S101-S105.

S101. Determine a plurality of input data sets of a multiplier and an encoding manner for the multiplier.

The electronic device may include a multiplier, which is configured to perform a multiplication operation on two pieces of data. The electronic device first obtains a plurality of input data sets, subsequently, may send the plurality of input data sets to the multiplier, and then, implements the operation method on the plurality of input data sets by using the multiplier. Each input data set in the plurality of input data sets may include a multiplicator and a multiplicand. The multiplicator and the multiplicand may be signed numbers or unsigned numbers.

In some embodiments, a maximum data bit width supported by the multiplier in the electronic device is N. Moreover, the multiplier supports multiplication operations with multiple data bit widths (which may be referred to as multiplication operations with multiple precision). A plurality of data bit widths supported by the multiplier are all less than N. In other words, the multiplier may be configured to perform a multiplication operation for two pieces of data with a data bit width of N, and a multiplication operation for two pieces of data with at least one other data bit width. The at least one other data bit width is less than N. N is a positive integer. For example, N is 32, 16, or 8.

In some embodiments, the electronic device may obtain a plurality of input data sets input by a user. Alternatively, the electronic device may generate a plurality of input data sets.

For example, the plurality of input data sets obtained by the electronic device may be divided into a multiplicator (which is referred to as a first multiplicator) and a multiplicand (which may be referred to as a first multiplicand). The first multiplicator is spliced by a plurality of second multiplicators. The first multiplicand is spliced by a plurality of second multiplicands. The plurality of second multiplicators are in one-to-one correspondence to the plurality of second multiplicands. Moreover, a second multiplicator and the corresponding second multiplicand form an input data set. A data bit width of the first multiplicator and a data bit width of the first multiplicand are both less than or equal to N. A data bit width of the second multiplicator is less than or equal to that of the first multiplicator, and a data bit width of the second multiplicand is less than or equal to that of the first multiplicand.

In some embodiments, the electronic device obtains a plurality of input data sets. The data bit widths of the second multiplicator and the second multiplicand included in each input data set in the plurality of input data sets may be the same or different. If the data bit widths of the second multiplicator and the second multiplicand in any input data set are different, the electronic device may preprocess the input data set to obtain a preprocessed input data set. Subsequently, the electronic device updates said any input data set to the preprocessed input data set. The data bit widths of the second multiplicator and the second multiplicand in the preprocessed input data set are the same, and numerical values of the input data set before and after the preprocessing are the same (including that numerical values of the second multiplicator before and after the preprocessing are the same, and numerical values of the second multiplicand before and after the preprocessing are the same).

Further, the electronic device may obtain a plurality of updated input data sets, and continue to perform S102 on the plurality of updated input data sets. Data bit widths of the second multiplicator and the second multiplicand included in each input data set in the plurality of updated input data sets are the same.

For example, an input data set includes a multiplicator with a data bit width of 8 bits and a multiplicand with a data bit width of 16 bits, and the electronic device may preprocess the multiplicator in the input data set to obtain a multiplicator with a data bit width of 16 bits. The preprocessing includes adding an 8-bit numerical value to a highest place of the multiplicator. Moreover, all 8-bit numerical values are 0.

It should be noted that in the embodiments of this disclosure, the operation method of multiplier provided in the embodiments of this disclosure is introduced by using an input data set including a second multiplicator and a second multiplicand that have a same data bit width as an example.

In some embodiments, data bit widths of different input data sets in the plurality of input data sets may be the same or different. Data bit width of each input data set may refer to the data bit width of the second multiplicator included in the input data set, or it may refer to the data bit width of the second multiplicand included in the input data set. For example, the plurality of input data sets include two 8-bit input data sets. For another example, the plurality of input data sets include a 8-bit input data set and a 16-bit input data set.

In some embodiments, the encoding manner for the multiplier may be saved in the electronic device in advance. For example, the encoding manner for the multiplier may be radix-4 booth encoding or radix-8 booth encoding.

It should be noted that a working principle for the multiplier to calculate a product operation result of a multiplicator and a multiplicand is as follows: a numerical value at a first place in the multiplicator is multiplied by all numerical values included in the multiplicand, to generate a set of product terms corresponding to the numerical value at the first place; a numerical value at a second place in the multiplicator is further multiplied by all the numerical values included in the multiplicand, to generate a set of product terms corresponding to the numerical value at the second place; and the others can be deduced by analogy. Subsequently, product terms (which may be referred to as a plurality sets of product terms) corresponding to all numerical values included in the multiplicator are arranged to obtain a partial product array (PPA). A process of "arranging the product terms corresponding to all the numerical values included in the multiplicator" may include: moving a set of product terms corresponding to the numerical value at the second place leftward by one place relative to a set of product terms corresponding to the numerical value at the first place; moving a set of product terms corresponding to a numerical value at a third place leftward by one place relative to a set of product terms corresponding to the numerical value at the second place; and the others can be deduced by analogy. Finally, the partial product array is accumulated to obtain the product operation result of the multiplicator and the multiplicand.

Both the multiplicator and the multiplicand may be binary numerals. If a numerical value in the multiplicator is 1, a set of product terms corresponding to this numerical value is a multiplicand. If a numerical value in the multiplicator is 0, a set of product terms corresponding to this numerical value are all 0.

It should also be noted that, the Booth encoding is used for transforming the multiplicator, so that a quantity of non-zero values included in the transformed multiplicator is reduced, thereby reducing a quantity of partial products and reducing a size of the PPA. In other words, the Booth encoding is used by the multiplier in the electronic device, which may accelerate a generation speed of the PPA. In addition, Booth encoding with different radixes may reduce different quantities of partial products. For example, the radix-4 booth encoding may reduce a quantity of rows of the partial products included in the PPA by half; and the radix-8 booth encoding may reduce the quantity of rows of the partial products included in the PPA by approximately 1/3.

For example, that both a multiplicator $A_{16}$ of int16 and a multiplicand $B_{16}$ of int16 are signed data is used as an example. The electronic device may generate a PPA for the multiplicator $A_{16}$ and the multiplicand $B_{16}$ by using the radix-4 booth encoding. As shown in FIG. 2, all black dots in the PPA shown in FIG. 2 represent product terms; s represents a sign bit obtained by performing booth encoding on the multiplicator $A_{16}$; e represents a sign bit of a set of product terms corresponding to each numerical value in the multiplicator $A_{16}$; and $\bar{e}$ represents a numerical value obtained by negating e in a first row of the PPA. Numerical values of all s in FIG. 2 are 1 or 0, and numerical values of s in different rows of the PPA may be the same or different. Numerical values of all e in FIG. 2 are 1 or 0, and numerical values of e in different rows of the PPA may be the same or different.

It may be learned that, there are 8 rows in a product term included in the PPA that is generated for the multiplicator $A_{16}$ and the multiplicand $B_{16}$ of int16 by the electronic device by using the radix-4 booth encoding. By using radix-4 booth, the electronic device reduces the quantity of rows in the product term included in the PPA from 16 to 8.

S102. Determine at least one low-order input data set in the plurality of input data sets.

The electronic device may determine the at least one low-order input data set from the plurality of input data sets based on a position of each input data set in the plurality of input data sets. The at least one low-order input data set includes input data sets except a highest-order-bit input data set in the plurality of input data sets. The highest-order-bit input data set refers to an input data set located at a highest-order bit in the plurality of input data sets.

In some embodiments, the position of each input data set in the plurality of input data sets may refer to a sequence number of each input data set in the plurality of input data sets, such as first, second, and third. The sequence number of each input data set in the plurality of input data sets indicates a sequence of bits occupied by the input data set in the plurality of input data sets. A lower sequence number of each input data set in the plurality of input data sets indicates a lower bit occupied by the input data set in the plurality of input data sets.

For example, that the plurality of input data sets include a first multiplicator $A_{32}$ with a data bit width of 32 bits and a first multiplicand $B_{32}$ with a data bit width of 32 bits is used as an example, where $A_{32}=a_{31} a_{30}...a_1a_0$, and $B_{32}=b_{31} b_{30}...b_1b_0$. The first multiplicator $A_{32}$ includes a plurality of second multiplicators, which respectively are a second multiplicator $A_{16-1}$ with a data bit width of 16 bits, a second multiplicator $A_{8-2}$ with a data bit width of 8 bits, and a second multiplicator $A_{8-3}$ with a data bit width of 8 bits. $A_{16-1}=a_{15} a_{14}...a_1a_0$, $A_{8-2}=a_{23} a_{22}...a_{17}a_{16}$, and $A_{8-3}=a_{31} a_{30}...a_{25}a_{24}$. Sequence numbers of the $A_{16-1}$, the $A_{8-2}$, and the $A_{8-3}$ in the plurality of input data sets (that is, the sequence numbers of the $A_{16-1}$, the $A_{8-2}$, and the $A_{8-3}$ in the first multiplicator $A_{32}$) are first, second, and third, respectively.

The first multiplicand $B_{32}$ includes a plurality of second multiplicands, which respectively are a second multiplicand $B_{16-1}$ with a data bit width of 16 bits, a second multiplicand $B_{8-2}$ with a data bit width of 8 bits, and a second multiplicand $B_{8-3}$ with a data bit width of 8 bits. $B_{16-1}=b_{15} b_{14}...b_1b_0$, $B_{8-2}=b_{23} b_{22}...b_{17}b_{16}$, and $B_{8-3}=b_{31} b_{30}...b_{25}b_{24}$. Sequence numbers of the $B_{16-1}$, the $B_{8-2}$, and the $B_{8-3}$ in the plurality of input data sets (that is, the sequence numbers of the $B_{16-1}$, the $B_{8-2}$, and the $B_{8-3}$ in the first multiplicand $B_{32}$) are first, second, and third, respectively.

For the first multiplicator $A_{32}$ and the first multiplicand $B_{32}$, it may be determined that the at least one low-order input data set includes: a low-order input data set consisting of the second multiplicator $A_{16-1}$ and the second multiplicand $B_{16-1}$, and another low-order input data set consisting of the second multiplicator $A_{8-2}$ and the second multiplicand $B_{8-2}$.

In some embodiments, in addition to the plurality of input data sets, the electronic device may also obtain an input signal. The input signal is used to indicate a data bit width of each input data set (which may be referred to as data accuracy of each input data set) included in the plurality of input data sets. The input signal may include a plurality sets of numerical values, which occupy different bits in the input signal. A position of each set of numerical values in the input signal is the same as that of an input data set corresponding to each set of numerical values in the plurality of input data sets (for example, a sequence number of each set of numerical values in the input signal is the same as that of an input data set corresponding to each set of numerical values in the plurality of input data sets). In this case, the electronic device may determine the position of each input data set in the plurality of input data sets based on the input signal.

Each set of numerical values may include one or more numerical values. Each set of numerical values may also be used to represent a data bit width of an input data set corresponding to this set of numerical values.

For example, an input signal dxlp may be data with a data bit width of 8 bits, where $dxlp=d_7d_6...d_1d_0$. Numerical values at a first bit and a second bit (that is, a numerical value of $d_1d_0$) in the input signal dxlp are used to indicate a data bit width of an input data set that ranks first among the plurality of input data sets. Numerical values at a third bit and a fourth bit (that is, a numerical value of $d_3d_2$) in the input signal dxlp are used to indicate a data bit width of an input data set that ranks second among the plurality of input data sets. Numerical values at a fifth bit and a sixth bit (that is, a numerical value of $d_5d_4$) in the input signal dxlp are used to indicate a data bit width of an input data set that ranks third among the plurality of input data sets. Numerical values at a seventh bit and an eighth bit (that is, a numerical value of $d_7d_6$) in the input signal dxlp are used to indicate a data bit width of an input data set that ranks fourth among the plurality of input data sets.

A numerical value representing a data bit width of an input data set in the input signal dxlp may be equal or not equal to the data bit width. For example, if $d_1d_0=01$, it indicates that the data bit width of the input data set that ranks first among the plurality of input data sets is 8 bits. For another example, if $d_7d_6=00$, it indicates that the data bit width of the input data set that ranks fourth among the plurality of input data sets is 0 bit. In this case, it may be learned that the plurality of input data sets do not include the input data set that ranks fourth.

It should be noted that in the foregoing examples, the input signal dxlp is introduced by using an example in which every two bits in the input signal dxlp represent the data bit width of an input data set. In the input signal dxlp, a plurality of bits of another quantity (such as 3 bits or 4 bits) may also be used to represent the data bit width of an input data set. Moreover, more bits indicate more types of data bit widths of an input data set represented by using the plurality of bits.

S103. Determine a carry compensation term corresponding to the at least one low-order input data set based on the at least one low-order input data set and the encoding manner.

It should be noted that, a PPA corresponding to the plurality of input data sets may be obtained during a process in which the electronic device calculates a product operation result of the plurality of input data sets by using one multiplier. The PPA may include sub PPAs corresponding to various input data sets (including a sub PPA corresponding to each low-order input data set). The sub PPA corresponding to each input data set is multiplied by using the input data set, to obtain the PPA. There is a carry during accumulation of the sub PPA corresponding to each low-order input data set in the plurality of input data sets, and the carry affects a product operation result of a high-order input data set corresponding to each low-order input data set. Therefore, the electronic device may determine the carry compensation term corresponding to the at least one low-order input data set in the plurality of input data sets. The carry compensation term corresponding to each low-order input data set is used to cancel out the carry during the accumulation of the sub PPA corresponding to the low-order input data set.

Bit positions, in the plurality of input data sets, occupied by the high-order input data set corresponding to each low-order input data set are greater than bit positions occupied by the low-order input data set in the plurality of input data sets. Moreover, the bits occupied by the high-order input data set in the plurality of input data sets are adjacent to those occupied by the low-order input data set in the plurality of input data sets. For example, for a low-order input data set consisting of the second multiplicator $A_{16-1}$ and the second multiplicand $B_{16-1}$, a corresponding high-order input data set includes the second multiplicator $A_{8-2}$ and the second multiplicand $B_{8-2}$.

It should also be noted that, the carry compensation term corresponding to each low-order input data set is used to cancel out the carry during the accumulation of the sub PPA corresponding to the low-order input data set; and the sub PPA corresponding to the low-order input data set depends on the second multiplicator and the second multiplicand included in the low-order input data set, and the encoding manner for the multiplier that is configured to generate the sub PPA. Therefore, the electronic device may determine the carry compensation term corresponding to each low-order input data set based on each low-order input data set and the encoding manner for the multiplier.

For example, the following example is used: A plurality of low-order input data sets include a first multiplicator $A_{16}$ of int16 and a first multiplicand $B_{16}$ of int16t; both the first multiplicator $A_{16}$ and the first multiplicand $B_{16}$ are signed data; the first multiplicator $A_{16}$ includes two second multiplicators (that is, a second multiplicator $A_{8-1}$ and a second multiplicator $A_{8-2}$); and the first multiplicand $B_{16}$ includes two second multiplicands (that is, a second multiplicand $B_{8-1}$ and a second multiplicand $B_{8-2}$). $A_{8-1}=a_7 a_6...a_1a_0$, $A_{8-2}=a_{15} a_{14}...a_9a_8$, $B_{8-1}=b_7 b_6...b_1b_0$, and $B_{8-2}=b_{15} b_{14}...b_9b_8$. Sequence numbers of the $A_{8-1}$ and the $A_{8-2}$ in the first multiplicator $A_{16}$ are first and second, respectively. Sequence numbers of the $B_{8-1}$ and the $B_{8-2}$ in the first multiplicand $B_{16}$ are first and second, respectively. An input data set (which may be referred to as a first input data set) consists of the second multiplicator $A_{8-1}$ and the second multiplicand $B_{8-1}$, and another input data set (which may be referred to as a second input data set) consists of the second multiplicator $A_{8-2}$ and the second multiplicand $B_{8-2}$. The first input data set is a low-order input data set, and a high-order input data set corresponding to the first input data set is the second input data set.

The electronic device may generate a PPA (which may be referred to as an initial PPA) for the first multiplicator $A_{16}$ and the first multiplicand $B_{16}$ by using the radix-4 booth encoding. The initial PPA includes a sub PPA corresponding to the first input data set and a sub PPA corresponding to the second input data set.

Referring to FIG. 3, the sub PPA corresponding to the first input data set includes: product terms represented by using all black dots from a first row to a fourth row, and all sign bits from the first row to the fourth row. All the sign bits from the first row to the fourth row include $s_0$, $e_0$, $\overline{e_0}$, and 1. $s_0$ represents a sign bit obtained by performing booth encoding on the second multiplicator $A_{8-1}$; $e_0$ represents a sign bit of a set of product terms corresponding to each numerical value in the second multiplicator $A_{8-1}$; and $\overline{e_0}$ represents a numerical value obtained by negating the $e_0$ in the first row of the PPA. Numerical values of all $s_0$ in FIG. 3 are 1 or 0, and numerical values of $s_0$ in different rows of the PPA may be the same or different. Numerical values of all $e_0$ in FIG. 3 are 1 or 0, and numerical values of $e_0$ in different rows of the PPA may be the same or different.

Referring to FIG. 3, the sub PPA corresponding to the second input data set includes: product terms represented by using all black dots from a fifth row to an eighth row, and all sign bits from the fifth row to the eighth row. All the sign bits from the fifth row to the eighth row include $s_1$, $e_1$, $\overline{e_1}$, and 1. $s_1$ represents a sign bit obtained by performing booth encoding on the second multiplicator $A_{8-2}$; $e_1$ represents a sign bit of a set of product terms corresponding to each numerical value in the second multiplicator $A_{8-2}$; and $\overline{e_1}$ represents a numerical value obtained by negating the $e_1$ in the fifth row of the PPA. Numerical values of all $s_1$ in FIG. 3 are 1 or 0, and numerical values of $s_1$ in different rows of the PPA may be the same or different. Numerical values of all $e_1$ in FIG. 3 are 1 or 0, and numerical values of $e_1$ in different rows of the PPA may be the same or different.

In this case, for a low-order input data set consisting of the second multiplicator $A_{8-1}$ and the second multiplicand $B_{8-1}$, the electronic device may determine a carry compensation term corresponding to the low-order input data set. The carry compensation term corresponding to the low-order input data set is used to cancel out a carry during accumulation of a sub PPA corresponding to the low-order input data set.

S104. Determine a target partial product array based on the carry compensation term corresponding to the at least one low-order input data set and the plurality of input data sets.

The electronic device may first generate the initial PPA by using the plurality of input data sets; and then obtain the target partial product array (that is, a target PPA) by combining the initial PPA with the carry compensation term corresponding to the at least one low-order input data set.

For example, the electronic device first generates the initial PPA by using the first multiplicator $A_{16}$ and the first multiplicand $B_{16}$, and then adds the carry compensation term corresponding to the low-order input data set consisting of the second multiplicator $A_{8\text{-}1}$ and the second multiplicand $B_{8\text{-}1}$ into the initial PPA, to obtain the target PPA shown in FIG. 3. E in the target PPA shown in FIG. 3 is the carry compensation term corresponding to the low-order input data set consisting of the second multiplicator $A_{8\text{-}1}$ and the second multiplicand $B_{8\text{-}1}$.

It may be learned that, a position of a carry during accumulation of a sub PPA corresponding to the low-order input data set consisting of the second multiplicator $A_{8\text{-}1}$ and the second multiplicand $B_{8\text{-}1}$ is located at a position of the carry compensation term E shown in FIG. 3. The carry compensation term E may cancel out the carry during the accumulation of the sub PPA corresponding to the low-order input data set, so that the carry during the accumulation of the sub PPA corresponding to the low-order input data set would not affect a product operation result of a high-order input data set (that is, an input data set consisting of the second multiplicator $A_{8\text{-}2}$ and the second multiplicand $B_{8\text{-}2}$) corresponding to the low-order input data set. In this way, accuracy of the product operation result of the high-order input data set is ensured. In addition, the product operation result of the low-order input data set is also accurate. In view of the above, the product operation result of each input data set is accurate, and thus multiplication operations with multiple precision may be implemented.

S105. Determine a product operation result for each input data set based on the target partial product array.

The electronic device may accumulate the target PPA to obtain an accumulation result. The accumulation result may be spliced with product operation results of various input data sets. Moreover, a position of the product operation result of each input data set in the accumulation result (for example, a sequence number of the product operation result of each input data set in the accumulation result) is the same as that of each input data set in the plurality of input data sets (for example, the sequence number of each input data set in the plurality of input data sets).

It should be noted that a data bit width of the plurality of input data sets is different from that of the accumulation result. For example, a data bit width of a plurality of input data sets is 16, while a data bit width of an accumulation result corresponding to the plurality of input data sets is 32. Therefore, it may be learned that bits occupied by each input data set in the plurality of input data sets are different from those, in the accumulation result, that are occupied by the product operation result of the input data set.

For example, a sequence number of an input data set in the plurality of input data sets is first, and the input data set occupies 1st-16th bits in the plurality of input data sets. The sequence number, in the accumulation result, of the product operation result of the input data set is also first. However, the product operation result of the input data set occupies 1st-32th bits in the accumulation result.

It may be understood that if the electronic device adds the carry compensation term corresponding to the at least one low-order input data set into the target PPA, it may be learned that the target PPA includes not only the sub PPA corresponding to each low-order input data set, but also the carry compensation term corresponding to each low-order input data set. In this way, during the process of accumulating the target PPA by the electronic device, the carry compensation term corresponding to each low-order input data set in the target PPA may cancel out the carry during the accumulation of the sub PPA corresponding to the low-order input data set, so that the carry during the accumulation of the sub PPA corresponding to each low-order input data set would not affect the product operation result of the high-order input data set corresponding to each low-order input data set. In this way, accuracy of the product operation result of the high-order input data set corresponding to each low-order input data set in the plurality of input data sets is ensured. In addition, the product operation result of the at least one low-order input data set in the plurality of input data sets is also accurate. In view of the above, the product operation result of each input data set is accurate, and thus multiplication operations with multiple precision may be implemented. Moreover, the operation method of multiplier provided in this disclosure does not require combination of a plurality of multipliers. Multiplication operations with multiple precision may be implemented by using one multiplier, thereby reducing hardware resource consumption and hardware area.

In addition, according to the foregoing relevant schemes, in the process of implementing a high-precision multiplication operation by using a plurality of low-precision multipliers, it is needed to accumulate a plurality of product operation results output by the plurality of multipliers by weight, so as to obtain a high-precision product operation result. In the process of accumulating the plurality of product operation results by weight, it is needed to shift the product operation results with different weights (for example, according to the relevant schemes, $A_H * B_H * 2^{16}$ is obtained by shifting a product operation result of $A_H * B_H$, $A_H * B_L * 2^8$ is obtained by shifting a product operation result of $A_H * B_L$, and $A_L * B_H * 2^8$ is obtained by shifting a product operation result of $A_L * B_H$). In the relevant schemes, a shift operation is performed, so that duration required for obtaining the high-precision product operation result is increased. In the embodiments of this disclosure, the electronic device accumulates the target PPA to obtain the product operation result (including the high-precision product operation result) of each input data set, without performing the shift operation. In this way, the duration required for obtaining the product operation result (including the high-precision product operation result) of each input data set may be reduced.

In some embodiments, a maximum data bit width supported by the multiplier in the electronic device is N. Therefore, after determining the plurality of input data sets, the electronic device may determine whether a sum of data bit widths of all the input data sets does not greater than (that is, being less than or equal to) N. If the sum of the data bit widths of all the input data sets is less than or equal to N, the electronic device may continue to implement an operation method for the plurality of input data sets. If the sum of the data bit widths of all the input data sets is greater than N, the electronic device may end the process.

For example, S102 in the operation method of multiplier provided in the embodiments of this disclosure may include the following step: determining the at least one low-order input data set in the plurality of input data sets in response to that the sum of the data bit widths of all the input data sets is less than or equal to N.

It may be understood that, by using a multiplier supporting a maximum data bit width of Nbit, the electronic device may perform a multiplication operation on an input data set with a data bit width less than Nbit, and may also perform a multiplication operation on a plurality of input data sets with a sum of data bit widths less than Nbit.

In some embodiments, to cancel out the carry during the accumulation of the sub PPA corresponding to each low-order input data set, it is needed to set a compensation position of the carry compensation term corresponding to each low-order input data set based on a position of the carry during the accumulation of the sub PPA corresponding to each low-order input data set; and set a compensation value of the carry compensation term corresponding to each low-order input data set based on a numerical value of the carry during the accumulation of the sub PPA corresponding to each low-order input data set.

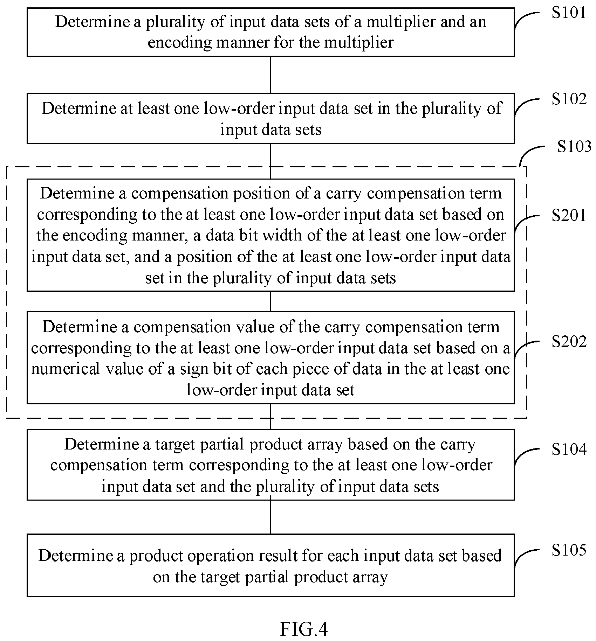

As shown in FIG. 4, on the basis of the embodiment shown in FIG. 1, S103 in the operation method of multiplier provided in the embodiments of this disclosure may further include the following steps S201 and S202.

S201. Determine a compensation position of the carry compensation term corresponding to the at least one low-order input data set based on the encoding manner, a data bit width of the at least one low-order input data set, and a position of the at least one low-order input data set in the plurality of input data sets.

The electronic device may determine a quantity of rows in the sub PPA corresponding to each low-order input data set based on the encoding manner for the multiplier, the data bit width of the second multiplicator included in each low-order input data set (that is, the data bit width of each low-order input data set), and the position of each low-order input data set in the plurality of input data sets. Subsequently, the electronic device determines the compensation position of the carry compensation term corresponding to each low-order input data set based on the quantity of rows in the sub PPA corresponding to each low-order input data set.

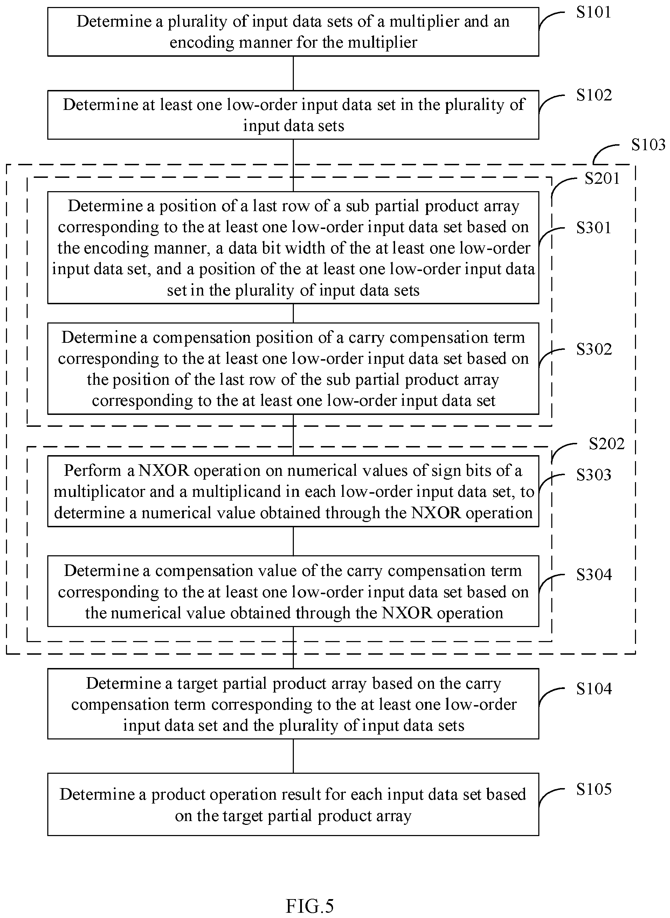

In some embodiments, the electronic device may determine a position of a last row of the sub PPA corresponding to each of the at least one low-order input data set based on the encoding manner for the multiplier, the data bit width of the at least one low-order input data set, and the position of the at least one low-order input data set in the plurality of input data sets; and then determine that the position of the last row of the sub PPA corresponding to each low-order input data set is the compensation position of the carry compensation term corresponding to the low-order input data set. As shown in FIG. 5, on the basis of the embodiment shown in FIG. 4, S201 in the operation method of multiplier provided in the embodiments of this disclosure may further include the following steps S301 and S302.

S301. Determine a position of a last row of a sub partial product array corresponding to the at least one low-order input data set based on the encoding manner, the data bit width of the at least one low-order input data set, and the position of the at least one low-order input data set in the plurality of input data sets.

The position of the last row of the sub PPA corresponding to each low-order input data set may refer to a number of the last row of the sub PPA in the PPA corresponding to the plurality of input data sets.

In some embodiments, the position of each low-order input data set in the plurality of input data sets may refer to a sequence number of each low-order input data set in the plurality of input data sets. Further, the electronic device may first determine a position of bits occupied by the at least one low-order input data set in the plurality of input data sets based on the data bit width of the at least one low-order input data set and the sequence number of the at least one low-order input data set in the plurality of input data sets; and then determine the position of the last row of the sub PPA corresponding to each low-order input data set based on the encoding manner for the multiplier and the position of the bits occupied by the at least one low-order input data set in the plurality of input data sets.

The plurality of input data sets may include a first multiplicator and a first multiplicand, and each low-order input data set may include a second multiplicator and a second multiplicand. The position of the bits occupied by each low-order input data set in the plurality of input data sets may refer to a position of bits occupied by the second multiplicator in the first multiplicator, or may refer to a position of bits occupied by the second multiplicand in the first multiplicand.

For example, that the plurality of input data sets are the first multiplicator $A_{32}$ and the first multiplicand $B_{32}$, and the at least one low-order input data set in the plurality of input data sets includes: a first low-order input data set consisting of the second multiplicator $A_{16-1}$ and the second multiplicand $B_{16-1}$, and a second low-order input data set consisting of the second multiplicator $A_{8-2}$ and the second multiplicand $B_{8-2}$ is used as an example. The electronic device determines positions of bits respectively occupied by the two low-order input data sets in the plurality of input data sets based on data bit widths of the two low-order input data sets and sequence numbers of the two low-order input data sets in the plurality of input data sets. The data bit width of the first low-order input data set is 16 bits, and the data bit width of the second low-order input data set is 8 bits. The first low-order input data set is at a first position in the plurality of input data sets, and the second low-order input data set is at a second position in the plurality of input data sets. The second low-order input data set occupies $17^{th}$-$24^{th}$ bits in the plurality of input data sets.

The position of the bits occupied by the first low-order input data set in the plurality of input data sets may refer a position of bits occupied by the second multiplicator $A_{16-1}$ in the first multiplicator $A_{32}$, or may refer to a position of bits occupied by the second multiplicand $B_{16-1}$ in the first multiplicand $B_{32}$. The position of the bits occupied by the second low-order input data set in the plurality of input data sets may refer to a position of bits occupied by the second multiplicator $A_{8-2}$ in the first multiplicator $A_{32}$, or may refer to a position of bits occupied by the second multiplicand $B_{8-2}$ in the first multiplicand $B_{32}$.

Further, an example in which the encoding manner for the multiplier is the radix-4 booth encoding is used. Based on the radix-4 booth encoding and that the first low-order input data set occupies 1st-$16^{th}$ bits in the plurality of input data sets, the electronic device may determine that a position of a last row of a sub PPA corresponding to the first low-order input data set is an eighth row. Similarly, based on the radix-4 booth encoding and that the second low-order input data set occupies the $17^{th}$-$24^{th}$ bits in the plurality of input data sets, the electronic device may determine that a position of a last row of a sub PPA corresponding to the second low-order input data set is a twelfth row.

S302. Determine the compensation position of the carry compensation term corresponding to the at least one low-order input data set based on the position of the last row of the sub partial product array corresponding to the at least one low-order input data set.

The electronic device may determine that the position of the last row of the sub PPA corresponding to each low-order input data set is the compensation position of the carry compensation term corresponding to the low-order input data set. For example, if the position of the last row of the sub PPA corresponding to the first low-order input data set is the eighth row, it may be learned that a compensation position of a carry compensation term corresponding to the first low-order input data set is an eighth row of the PPA corresponding to the plurality of input data sets. For another example, if the position of the last row of the sub PPA corresponding to the second low-order input data set is the twelfth row, it may be learned that a compensation position of a carry compensation term corresponding to the second low-order input data set is a twelfth row of the PPA corresponding to the plurality of input data sets.

It may be understood that the carry during the accumulation of the sub PPA corresponding to each low-order input data set is in the last row of the sub PPA. Therefore, the compensation position of the carry compensation term corresponding to the low-order input data set is set in the last row of the sub PPA, so that the carry compensation term corresponding to the low-order input data set may cancel out the carry during the accumulation of the sub PPA corresponding to the low-order input data set.

S202. Determine a compensation value of the carry compensation term corresponding to the at least one low-order input data set based on a numerical value of a sign bit of each piece of data in the at least one low-order input data set.

The electronic device may determine the compensation value of the carry compensation term corresponding to each low-order input data set based on the numerical value of the sign bit of each piece of data in each low-order input data set. If each low-order input data set may include a second multiplicator and a second multiplicand, the numerical value of the sign bit of each piece of data in each low-order input data set may include a numerical value of a sign bit of the second multiplicator and a numerical value of a sign bit of the second multiplicand.

For example, each piece of data (for example, the second multiplicator or the second multiplicand) in each low-order input data set may include a sign bit, a numerical value of which is used to represent a symbol type of each piece of data. For example, the numerical value of the sign bit included in the second multiplicator is 1, indicating that a symbol type of the second multiplicator is negative. For another example, the numerical value of the sign bit included in the second multiplicator is 0, indicating that the symbol type of the second multiplicator is positive.

In some embodiments, the electronic device may determine the compensation value of the carry compensation term corresponding to the low-order input data set based on the numerical value of the sign bit of each piece of data included in each low-order input data set. As shown in FIG. 5, on the basis of the embodiment shown in FIG. 4, S202 in the operation method of multiplier provided in the embodiments of this disclosure may further include the following steps S303 and S304.

S303. Perform a NXOR operation on numerical values of sign bits of a multiplicator and a multiplicand in each low-order input data set, to determine a numerical value obtained through the NXOR operation.

Each low-order input data set includes a multiplicator (that is, the second multiplicator) and a multiplicand (that is, the second multiplicand). Thus, the electronic device may perform a NXOR operation on the numerical value of the sign bit in the second multiplicator and the numerical value of the sign bit in the second multiplicand, to determine a numerical value obtained through the NXOR operation. The numerical value of the sign bit included in the second multiplicator is used to represent a symbol type of the second multiplicator. The numerical value of the sign bit included in the second multiplicand is used to represent a symbol type of the second multiplicand.

For example, the numerical value of the sign bit included in the second multiplicator may be 0 or 1. The numerical value of the sign bit included in the second multiplicand may be 0 or 1. The numerical value obtained through the NXOR operation may be 0 or 1. A symbol type represented by using 0 may be positive, and a symbol type represented by using 1 may be negative.

For example, the electronic device performs a NXOR operation on 0 and 1, and a numerical value obtained through the NXOR operation is 0. For another example, the electronic device performs a NXOR operation on 1 and 1, and a numerical value obtained through the NXOR operation is 1. For another example, the electronic device performs a NXOR operation on 0 and 0, and a numerical value obtained through the NXOR operation is 1.

In some embodiments, a symbol type represented by using the numerical value obtained through the NXOR operation of each low-order input data set is opposite to that of the product operation result of the low-order input data set.

For example, if the numerical value of the sign bit of the second multiplicator included in a low-order input data set indicates that the symbol type of the second multiplicator is positive, and the numerical value of the sign bit of the second multiplicand included in the low-order input data set indicates that the symbol type of the second multiplicand is positive, the electronic device performs a NXOR operation on the numerical value of the sign bit of the second multiplicator and the numerical value of the sign bit of the second multiplicand to determine a numerical value obtained through the NXOR operation. A symbol type represented by using the numerical value obtained through the NXOR operation is negative. If the symbol type of the product operation result corresponding to the low-order input data set is positive, it may be learned that the symbol type represented by using the numerical value obtained through the NXOR operation is opposite to that of the product operation result corresponding to the low-order input data set.

For another example, if the numerical value of the sign bit of the second multiplicator included in a low-order input data set indicates that the symbol type of the second multiplicator is positive, and the numerical value of the sign bit of the second multiplicand included in the low-order input data set indicates that the symbol type of the second multiplicand is negative, the electronic device performs a NXOR operation on the numerical value of the sign bit of the second multiplicator and the numerical value of the sign bit of the second multiplicand to determine a numerical value obtained through the NXOR operation. A symbol type represented by using the numerical value obtained through the NXOR operation is negative. If the symbol type of the product operation result corresponding to the low-order input data set is negative, it may be learned that the symbol type represented by using the numerical value obtained through the NXOR operation is opposite to that of the product operation result corresponding to the low-order input data set.

S304. Determine the compensation value of the carry compensation term corresponding to the at least one low-order input data set based on the numerical value obtained through the NXOR operation.

The electronic device may determine that the numerical value obtained through the NXOR operation of each low-order input data set is the compensation value of the carry compensation term corresponding to the low-order input data set. For example, if the numerical value obtained through the NXOR operation of a low-order input data set is 0, it may be determined that the compensation value of the carry compensation term corresponding to the low-order input data set is 0. For another example, if the numerical value obtained through the NXOR operation of a low-order input data set is 1, it may be determined that the compensation value of the carry compensation term corresponding to the low-order input data set is 1.

It should be noted that the electronic device usually calculates the PPA by using binary numbers corresponding to a plurality of input data sets. Therefore, the numerical value in the sub PPA corresponding to each low-order input data set is 0 or 1, and the carry during the accumulation of the sub PPA corresponding to each low-order input data set is also 0 or 1. In addition, a symbol value of the product operation result of each low-order input data set represents the symbol type of the product operation result of the low-order input data set, and the symbol value is 0 or 1. A symbol type represented by using a numerical value obtained by negating the symbol value (for example, a value obtained by negating 0 is 1, and a value obtained by negating 1 is 0) is opposite to that of the product operation result corresponding to the low-order input data set. Moreover, the numerical value obtained by negating the symbol value may cancel out the carry during the accumulation of the sub PPA corresponding to the low-order input data set. If a symbol type represented by using the numerical value obtained through the NXOR operation of the low-order input data set is also opposite to that of the product operation result corresponding to the low-order input data set, it may be learned that the numerical value obtained through the NXOR operation is equal to the numerical value obtained through negation. Moreover, the numerical value obtained through the NXOR operation may also cancel out the carry during the accumulation of the sub PPA corresponding to the low-order input data set.

If both the first multiplicator and the second multiplicand included in the plurality of input data sets are binary numbers, the binary numbers corresponding to the plurality of input data sets are the first multiplicator and the second multiplicand. If the first multiplicator and the second multiplicand included in the plurality of input data sets are not binary numbers, the electronic device may respectively convert the first multiplicator and the second multiplicand, to obtain a converted first multiplicator and a converted second multiplicand. If the converted first multiplicator and the converted second multiplicand are both binary numbers, the binary numbers corresponding to the plurality of input data sets include the converted first multiplicator and the converted second multiplicand.

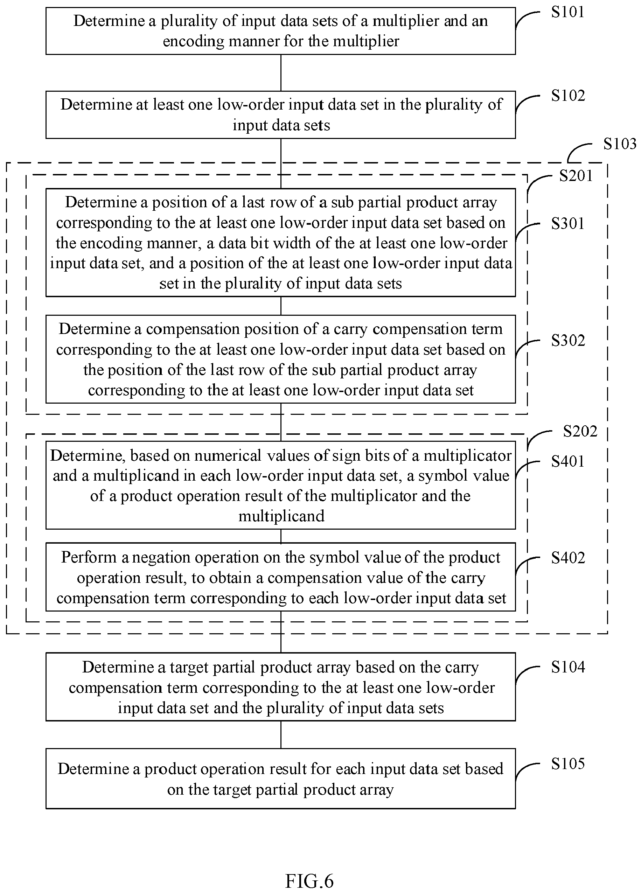

In some other embodiments, the electronic device may first determine a symbol value based on a numerical value of a sign bit of each piece of data included in each low order input data set. The symbol value represents the symbol type of the product operation result of the low-order input data set. Subsequently, the electronic device may determine the compensation value of the carry compensation term corresponding to the low-order input data set based on the symbol value. As shown in FIG. 6, on the basis of the embodiment shown in FIG. 4, S202 in the operation method of multiplier provided in the embodiments of this disclosure may further include the following steps S401 and S402.

S401. Determine, based on numerical values of sign bits of a multiplicator and a multiplicand in each low-order input data set, a symbol value of a product operation result of the multiplicator and the multiplicand.

The electronic device may determine a symbol value of a product operation result of the second multiplicator and the second multiplicand (that is, the symbol value of the product operation result of the low-order input data set) based on the numerical value of the sign bit of the second multiplicator and the numerical value of the sign bit of the second multiplicand that are included in each low-order input data set.

For example, if a numerical value of a sign bit included in a second multiplicator is 0, and a numerical value of a sign bit included in a second multiplicand is 0, a symbol value of a product operation result of the second multiplicator and the second multiplicand is 0. For another example, if a numerical value of a sign bit included in a second multiplicator is 0, and a numerical value of a sign bit included in a second multiplicand is 1, a symbol value of a product operation result of the second multiplicator and the second multiplicand is 1. For further another example, if a numerical value of a sign bit included in a second multiplicator is 1, and a numerical value of a sign bit included in a second multiplicand is 1, a symbol value of a product operation result of the second multiplicator and the second multiplicand is 0. A symbol type represented by using the numerical value 0 may be positive, and a symbol type represented by using the numerical value 1 may be negative.

S402. Perform a negation operation on the symbol value of the product operation result, to obtain the compensation value of the carry compensation term corresponding to each low-order input data set.

For example, if the symbol value of the product operation result of a low-order input data set is 0, it indicates that the symbol type of the product operation result is positive. In the case, the electronic device may obtain that the compensation value of the carry compensation term corresponding to the low-order input data set is 1. For another example, if the symbol value of the product operation result of a low-order input data set is 1, it indicates that the symbol type of the product operation result is negative. In the case, the electronic device may obtain that the compensation value of the carry compensation term corresponding to the low-order input data set is 0.

It may be understood that, the symbol value of the product operation result of each low-order input data set represents the symbol type of the product operation result of the low-order input data set, and the symbol value is 0 or 1. A symbol type represented by using a numerical value obtained by negating the symbol value is opposite to that of the product operation result corresponding to the low-order input data set. Moreover, the numerical value obtained by negating the symbol value may cancel out the carry during the accumulation of the sub PPA corresponding to the low-order input data set. Therefore, the electronic device may determine the numerical value obtained by negating the symbol value as the compensation value of the carry compensation term corresponding to the low-order input data set. The compensation value of the carry compensation term corresponding to the low-order input data set may cancel out the carry during the accumulation of the sub PPA corresponding to the low-order input data set.

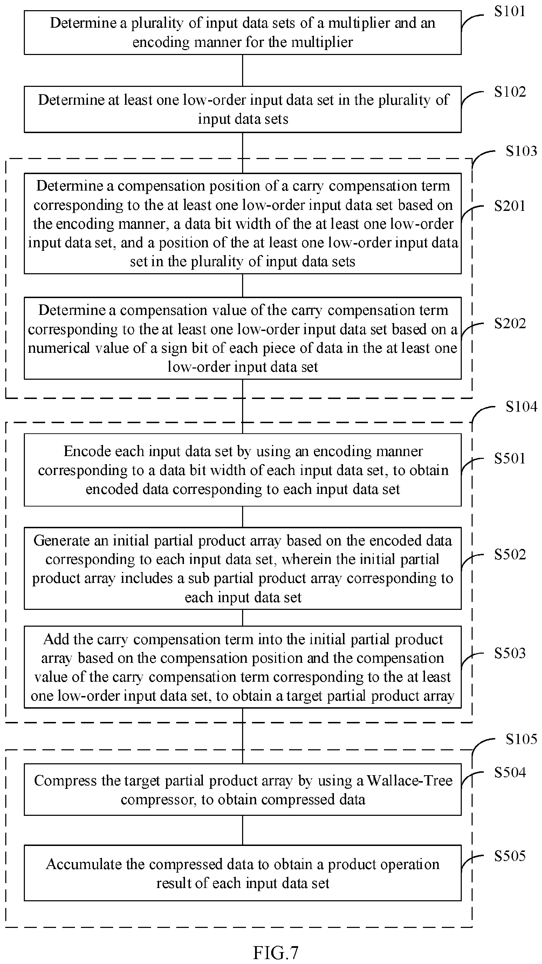

In some embodiments, after obtaining the carry compensation term corresponding to the at least one low-order input data set, the electronic device may first generate the initial PPA based on the plurality of input data sets; and then add the carry compensation term into the initial PPA, to obtain the target PPA. As shown in FIG. 7, on the basis of the embodiment shown in FIG. 4, S104 in the operation method of multiplier provided in the embodiments of this disclosure may further include the following steps S501-S503.

S501. Encode each input data set by using an encoding manner corresponding to the data bit width of each input data set, to obtain encoded data corresponding to each input data set.

As the electronic device calculates the product operation result of each input data set, the electronic device may encode (for example, through the booth encoding) each input data set separately to obtain the encoded data corresponding to each input data set. The encoded data corresponding to each input data set may be a plurality sets of product terms.

It should be noted that, for details about the plurality sets of product terms, reference may be made to the introduction to the plurality sets of product terms in the foregoing embodiments. Details are not described again in the embodiments of this disclosure.

For example, the plurality of input data sets include an input data set with a data bit width of $n_1$ bit and an input data set with a data bit width of $n_2$ bit. The electronic device may encode the input data set with the data bit width of $n_1$ bit by using $n_1$-bit booth encoding, and encode the input data set with the data bit width of $n_2$ bit by using $n_2$-bit booth encoding.

Further, if the encoding manner for the multiplier is the radix-4 booth encoding, the electronic device may encode the input data set with the data bit width of $n_1$ bit by using $n_1$-bit radix-4 booth encoding, and encode the input data set with the data bit width of $n_2$ bit by using $n_2$-bit radix-4 booth encoding.

In some embodiments, the electronic device may first use a selector to configure the multiplier to use the encoding manner corresponding to the data bit width of each input data set; and then encode each input data set by using the configured multiplier, to obtain the encoded data corresponding to each input data set.

S502. Generate an initial partial product array based on the encoded data corresponding to each input data set, where the initial partial product array includes the sub partial product array corresponding to each input data set.

The electronic device may generate the sub PPA corresponding to each input data set by using the encoded data corresponding to each input data set; and then generate the initial PPA corresponding to the plurality of input data sets based on the sub PPA corresponding to each input data set. The sub PPAs corresponding to different input data sets occupy different columns in the initial PPA.

In some embodiments, the encoded data corresponding to each input data set may be a plurality sets of product terms, and the electronic device may arrange the plurality sets of product terms to obtain the sub PPA corresponding to each input data set.

It should be noted that, for details about arranging the plurality sets of product terms by the electronic device, reference may be made to the introduction to "arranging the product terms corresponding to all the numerical values included in the multiplicator" in the foregoing embodiments. Details are not described again in the embodiments of this disclosure.

S503. Add the carry compensation term into the initial partial product array based on the compensation position and the compensation value of the carry compensation term corresponding to the at least one low-order input data set, to obtain the target partial product array.

The electronic device may add the carry compensation term corresponding to the at least one low-order input data set into the initial PPA, to obtain the target PPA.

In some embodiments, the initial PPA includes the sub PPA corresponding to the at least one low-order input data set. The compensation position corresponding to each low-order input data set is the position of the last row of the sub PPA corresponding to the low-order input data set. In this way, the electronic device may add, based on the position of the last row of the sub PPA corresponding to each low-order input data set, the compensation value of the carry compensation term corresponding to the low-order input data set into the last row of the sub PPA corresponding to the low-order input data set, so that the carry compensation term corresponding to the low-order input data set is added into the initial PPA. The electronic device adds the carry compensation term corresponding to the at least one low-order input data set into the initial PPA, to obtain the target PPA.

For example, the electronic device may set all target high bits in the last row of the sub PPA corresponding to each low-order input data set as the compensation value of the carry compensation term corresponding to the low-order input data set. The target high bit refers to a bit, in the last row of the sub PPA corresponding to the low order input data set, whose position is higher than a position of a partial product and a position of the sign bit.

It may be understood that in the embodiments of this disclosure, the plurality of input data sets are not encoded as an entirety, but each input data set is encoded separately to obtain the encoded data corresponding to each input data set. In this way, the electronic device may generate the sub PPA corresponding to each input data set by using the encoded data corresponding to each input data set; and then generate the initial PPA including the sub PPA corresponding to each input data set. The product operation result of each input data set may be obtained based on the initial PPA.

In some embodiments, the electronic device may accumulate the target PPA to obtain the product operation result of each input data set. Alternatively, the electronic device may first compress the target PPA to obtain compressed data; and then accumulate the compressed data to obtain the product operation result of each input data set.

For example, the process in which the electronic device obtains the product operation result of each input data set is described by using an example in which the electronic device obtains the product operation result of each input data group by using the compressed target PPA. Specifically, as shown in FIG. 7, on the basis of the embodiment shown in FIG. 4, S105 in the operation method of multiplier provided in the embodiments of this disclosure may further include the following steps S504 and S505.

S504. Compress the target partial product array by using a Wallace-tree compressor, to obtain compressed data.

The electronic device may compress the target PPA by using the Wallace-tree compressor (which may also be referred to as a Wallace-tree multiplier), to obtain the compressed data. The compressed data may include two sets of numerical values, which respectively are a product accumulation value of the target PPA and a numerical value of a carry of the target PPA.

S505. Accumulate the compressed data to obtain the product operation result of each input data set.

The electronic device may accumulate the two sets of numerical values included in compressed data, to obtain an accumulation result. The accumulation result includes the product operation result of each input data set. A data bit width of the accumulation result is 2N.

It may be understood that, the electronic device compresses the target PPA by using the Wallace-tree compressor, to obtain compressed data. Compared to an amount of data included in the target PPA, the compressed data contains less data. Thus, a speed of accumulating the compressed data may be improved, so that the production operation result of each input data set may be obtained quickly.

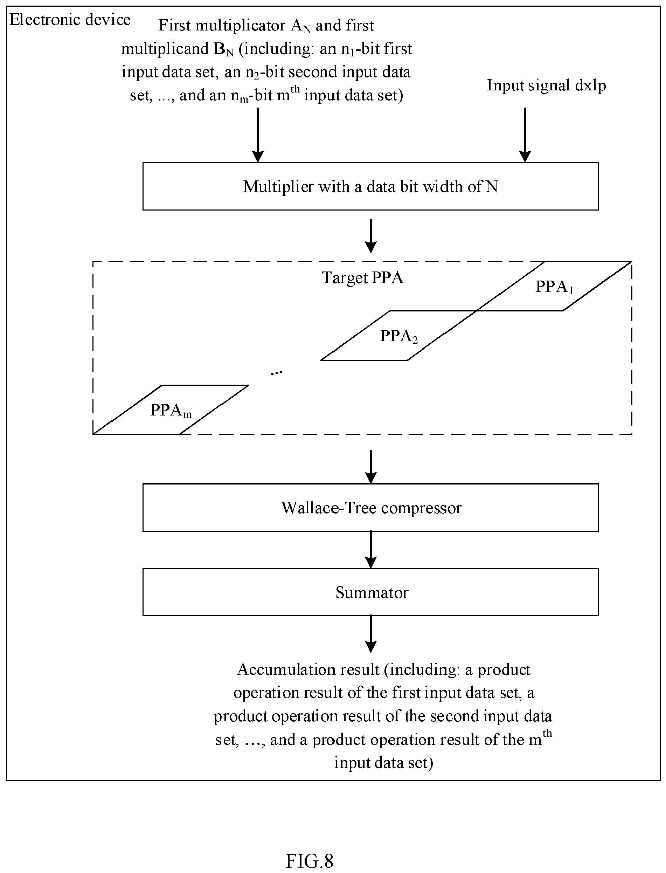

For example, referring to FIG. 8, an operation method of multiplier provided in the embodiments of this disclosure is introduced by using the electronic device shown in FIG. 8 as an example. The electronic device shown in FIG. 8 includes a multiplier with a data bit width of N, a Wallace-tree compressor, and a summator. The electronic device may perform the following steps to implement the operation method.

Step 1. The electronic device obtains a plurality of input data sets, an input signal dlxp, and the encoding manner for the multiplier.

For example, the plurality of input data sets include a first multiplicator $A_N$ and a first multiplicand $B_N$. The input signal dlxp is used to represent the data bit width of each input data set. Specifically, the input signal dlxp may be used to indicate that a data bit width of an input data set that ranks first (which may be referred to as a first input data set for short) in the plurality of input data sets is $n_1$bit; a data bit width of an input data set that ranks second (which may be referred to as a second input data set for short) is $n_2$bit; ...; and a data bit width of an input data set that ranks $m^{th}$ (which may be referred to as an $m^{th}$ input data set for short) is $n_m$bit. The encoding manner for the multiplier if booth encoding, m is a positive integer.

Step 2. The electronic device uses the multiplier to encode each input data set by using the encoding manner corresponding to the data bit width of each input data set, to obtain encoded data corresponding to each input data set.

Step 2 may include: The electronic device uses the multiplier to encode the first input data set by using the $n_1$-bit booth encoding, encode the second input data set by using the $n_2$-bit booth encoding, ..., and encode the $m^{th}$ input data set by using $n_m$-bit booth encoding, to obtain encoded data corresponding to the first input data set, encoded data corresponding to the second input data set, ..., and encoded data corresponding to the $m^{th}$ input data set.

Step 3. The electronic device uses the multiplier to generate the sub PPA corresponding to each input data set by using the encoded data corresponding to each input data set; and then generates the initial PPA corresponding to the plurality of input data sets based on the sub PPA corresponding to each input data set. Sub PPAs corresponding to all the input data sets include: a sub PPA (that is, $PPA_1$) corresponding to the first input data set, a sub PPA (that is, $PPA_2$) corresponding to the second input data set, ..., and a sub PPA (that is, $PPA_m$) corresponding to the $m^{th}$ input data set.

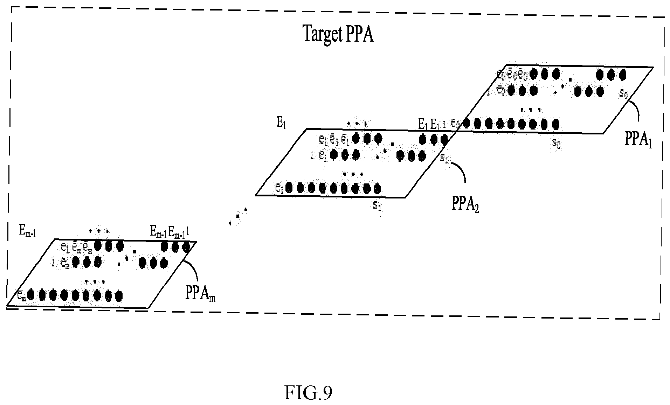

For example, referring to FIG. 8, as shown in FIG. 9, that the data bit width of $n_1$bit of the first input data set, the data bit width of $n_2$bit of the second input data set, ..., and the data bit width of $n_m$bit of the $m^{th}$ input data set are all equal to 8, and the encoding manner for the multiplier is the radix-4 booth encoding is used as an example. The electronic device may obtain the sub PPAs corresponding to all the input data set shown in FIG. 9, including the sub PPA corresponding to the first input data set (that is, the $PPA_1$), the sub PPA corresponding to the second input data set (that is, the $PPA_2$), ..., and the sub PPA corresponding to the $m^{th}$ input data set (that is, the $PPA_m$).

It should be noted that, for details about the $PPA_1$ shown in FIG. 9, reference may be made to the introduction to the sub PPA corresponding to the first input data set shown in FIG. 3 in the foregoing embodiments; for details about the $PPA_2$ shown in FIG. 9, reference may be made to the introduction to the sub PPA corresponding to the second input data set shown in FIG. 3 in the foregoing embodiments; and for details about the $PPA_m$ shown in FIG. 9, reference may be made to the introduction to the sub PPA corresponding to the first input data set shown in FIG. 3 in the foregoing embodiments. Details are not described again in the embodiments of this disclosure.

Step 4. The electronic device uses the multiplier to determine the carry compensation term corresponding to the at least one low-order input data set based on the at least one low-order input data set and the encoding manner; and then adds the carry compensation term corresponding to the at least one low-order input data set into the initial PPA, to obtain the target PPA. The at least one low-order input data set includes the first input data set, the second input data set, ..., and an $(m-1)^{th}$ input data set.

For example, referring to FIG. 8, as shown in FIG. 9, the carry compensation term corresponding to the at least one low-order input data set that is determined by the electronic device may include: a carry compensation term $E_1$ corresponding to the first input data set, a carry compensation term $E_2$ corresponding to the second input data set, ..., and a carry compensation term $E_{m-1}$ corresponding to the $(m-1)^{th}$ input data set. Thus, the electronic device may obtain the target PPA shown in FIG. 9.

Step 5. The electronic device compresses the target PPA by using the Wallace-tree compressor, to obtain compressed data.

Step 6. The electronic device accumulates the compressed data by using the summator, to obtain the product operation result of each input data set. A data bit width of an accumulation result that may be obtained by accumulating the compressed data by the electronic device is 2N. The accumulation result includes the product operation result of each input data set. For example, a product operation result of the first input data set is a numerical value represented by using 1st-$(2*n_1)^{th}$ bits in the accumulation result; and a product operation result of the second input data set is a numerical value represented by using $(2*n_1+1)^{th}$-$(2*n_2)^{th}$ bits in the accumulation result.

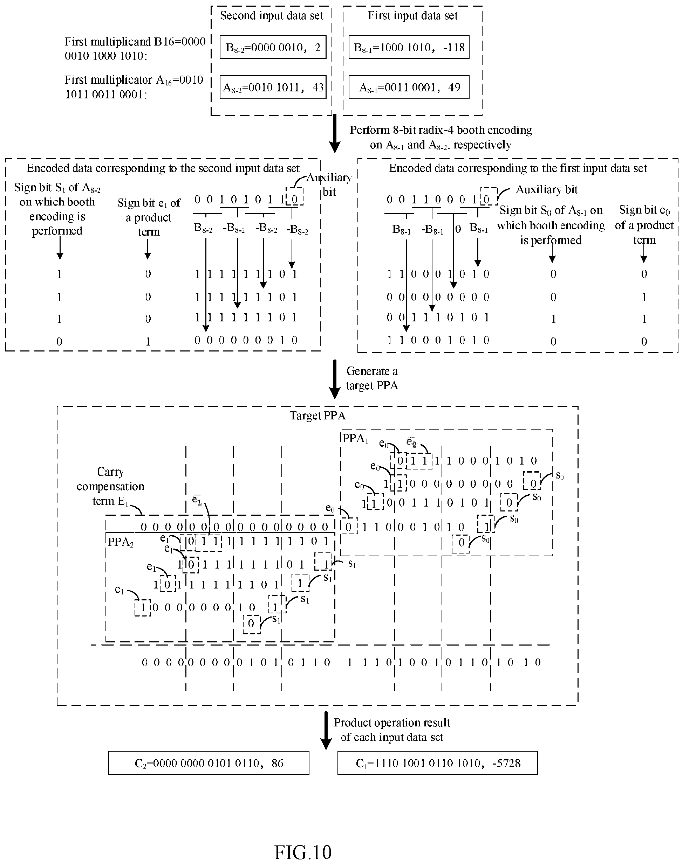

For example, referring to FIG. 10, that the plurality of input data sets include the first multiplicator $A_{16}$ of int16 and the first multiplicand $B_{16}$ of int16 shown in FIG. 10 is used as an example. The electronic device calculates $B_{16}*A_{16}$. The first multiplicator $A_{16}$ and the first multiplicand $B_{16}$ are both signed data. The first multiplicator $A_{16}$ includes the second multiplicator $A_{8-1}$ and the second multiplicator $A_{8-2}$ shown in FIG. 10, and the first multiplicand $B_{16}$ includes the second multiplicand $B_{8-1}$ and the second multiplicand $B_{8-2}$ shown in FIG. 10. $A_{16}=(0010101100110001)_2$, $A_{8-1}=(00110001)_2$, and $A_{8-2}=(00101011)_2$. $A_{8-1}$ represents a decimal number of 49, and $A_{8-2}$ represents a decimal number of 43. $B_{16}=(0000001010001010)_2$, $B_{8-1}=(10001010)_2$, and $B_{8-2}=(00000010)_2$. $B_{8-1}$ represents a decimal number of -118, and $B_{8-2}$ represents a decimal number of 2.

It should be noted that abbreviations for all binary numbers are shown in FIG. 10. For example, an abbreviation for $(0010101100110001)_2$ is 0010101100110001, and an abbreviation for $(00110001)_2$ is 00110001.

First, if a data bit width of the first input data set consisting of the second multiplicator $A_{8-1}$ and the second multiplicand $B_{8-1}$ is 8 bits, and a data bit width of the second input data set consisting of the second multiplicator $A_{8-2}$ and the second multiplicand $B_{8-2}$ is 8 bits, the electronic device may encode the first input data set by using 8-bit radix-4 booth encoding, to obtain encoded data corresponding to the first input data set; and encode the second input data set by using the 8-bit radix-4 booth encoding, to obtain encoded data corresponding to the second input data set.

Subsequently, the electronic device may generate the sub PPA (that is, the $PPA_1$) corresponding to the first input data set based on the encoded data corresponding to the first input data set, and generate the sub PPA (that is, the $PPA_2$) corresponding to the second input data set based on the encoded data corresponding to the second input data set.

Subsequently, if the electronic device may determine that the first input data set is a low-order input data set, the first input data set corresponds to the carry compensation term $E_1$. The electronic device determines the carry compensation term $E_1$ corresponding to the first input data set according to the following steps: If a numerical value of a sign bit of the second multiplicator $A_{8-1}$ in the first input data set is 0, and a numerical value of a sign bit of the second multiplicand $B_{8-1}$ in the first input data set is 1, the electronic device may determine that a symbol value of a product operation result of the second multiplicand $B_{8-1}$ and the second multiplicator $A_{8-1}$ is 1; a negation operation is performed on the symbol value of the product operation result to obtain a compensation value of 0 for the carry compensation term $E_1$ corresponding to the first input data set; and subsequently, it may be determined that a position of a last row of the sub PPA corresponding to the first input data set (that is, a fourth row of the $PPA_1$) is a compensation position of the carry compensation term $E_1$ corresponding to the first input data set.

Further, the electronic device may generate the target PPA shown in FIG. 10; and then may determine, based on the target PPA, a product operation result $C_1$ for the first input data set and a product operation result $C_2$ for the second input data set. $C_1=(1110100101101010)_2$. $C_1$ represents a decimal number of -5728, which is equal to a product of $B_{8-1}$ and $A_{8-1}$ (that is, a product of -118 and 49). $C_2=(0000000001010110)_2$. $C_2$ represents a decimal number of 86, which is equal to a product of $B_{8-2}$ and $A_{8-2}$ (that is, a product of 2 and 43).

It should be noted that, for details about sign bits shown in FIG. 10 (including $s_0$, $e_0$, $\overline{e_0}$, $s_1$, $e_1$, $\overline{e_1}$, and 1), reference may be made to the introduction to the sign bits shown in FIG. 3 (including $s_0$, $e_0$, $\overline{e_0}$, $s_1$, $e_1$, $\overline{e_1}$, and 1) in the foregoing embodiments. Details are not described again in the embodiments of this disclosure.

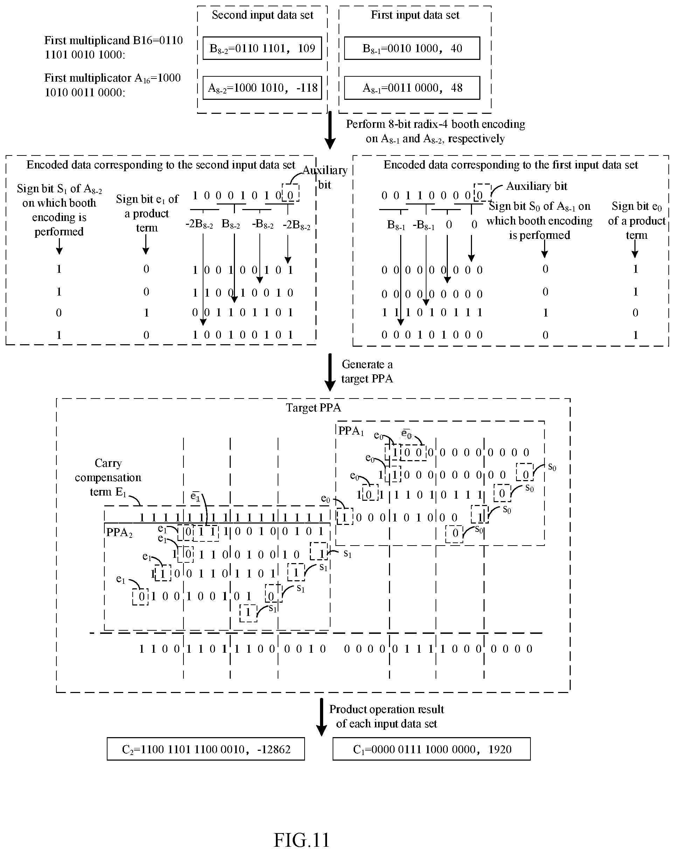

For example, referring to FIG. 11, that the plurality of input data sets include the first multiplicator $A_{16}$ of int16 and the first multiplicand $B_{16}$ of int16 shown in FIG. 11 is used as an example. The electronic device calculates $B_{16}*A_{16}$. The first multiplicator A16 and the first multiplicand B16 are both signed data. The first multiplicator A16 includes the second multiplicator $A_{8-1}$ and the second multiplicator $A_{8-2}$ shown in FIG. 11, and the first multiplicand $B_{16}$ includes the second multiplicand $B_{8-1}$ and the second multiplicand $B_{8-2}$ shown in FIG. 11. $A_{16}=(1000101000110000)_2$, $A_{8-1}=(00110000)_2$, and $A_{8-2}=(10001010)_2$. $A_{8-1}$ represents a decimal number of 48, and $A_{8-2}$ represents a decimal number of -118. $B_{16}=(0110110100101000)_2$, $B_{8-1}=(00101000)_2$, and $B_{8-2}=(01101101)_2$. $B_{8-1}$ represents a decimal number of 40, and $B_{8-2}$ represents a decimal number of 109.

It should be noted that abbreviations for all binary numbers are shown in FIG. 11. For example, an abbreviation for $(1000101000110000)_2$ is 1000101000110000, and an abbreviation for $(00110000)_2$ is 00110000.

If the electronic device may determine that the first input data set shown in FIG. 11 is a low-order input data set, it may be determined that the first input data set corresponds to the carry compensation term $E_1$. The electronic device determines the carry compensation term $E_1$ corresponding to the first input data set shown in FIG. 11 according to the following steps: If a numerical value of a sign bit of the second multiplicator $A_{8-1}$ in the first input data set is 0, and a numerical value of a sign bit of the second multiplicand $B_{8-1}$ in the first input data set is 0, the electronic device may determine that a symbol value of a product operation result of the second multiplicand $B_{8-1}$ and the second multiplicator $A_{8-1}$ is 0; a negation operation is performed on the symbol value of the product operation result to obtain a compensation value of 1 for the carry compensation term $E_1$ corresponding to the first input data set; and subsequently, it may be determined that a position of a last row of the sub PPA corresponding to the first input data set (that is, a fourth row of

the PPA$_1$) is a compensation position of the carry compensation term E$_1$ corresponding to the first input data set.

Further, the electronic device may generate the target PPA shown in FIG. 11; and then may determine, based on the target PPA, a product operation result C$_1$ for the first input data set and a product operation result C$_2$ for the second input data set. C$_1$= (0000011110000000)$_2$. C$_1$ represents a decimal number of 1920, which is equal to a product of B$_{8-1}$ and A$_{8-1}$ (that is, a product of 40 and 48). C$_2$= (1100110111000010)$_2$. C$_2$ represents a decimal number of -12862, which is equal to a product of B$_{8-2}$ and A$_{8-2}$ (that is, a product of 109 and -118).

It should be noted that, a process for the electronic device to implement the operation method of multiplier for a plurality of input data sets shown in FIG. 11 is similar to the process for the electronic device to implement the operation method of multiplier for a plurality of input data sets shown in FIG. 10. Details are not described again in the embodiments of this disclosure.

Exemplary apparatus

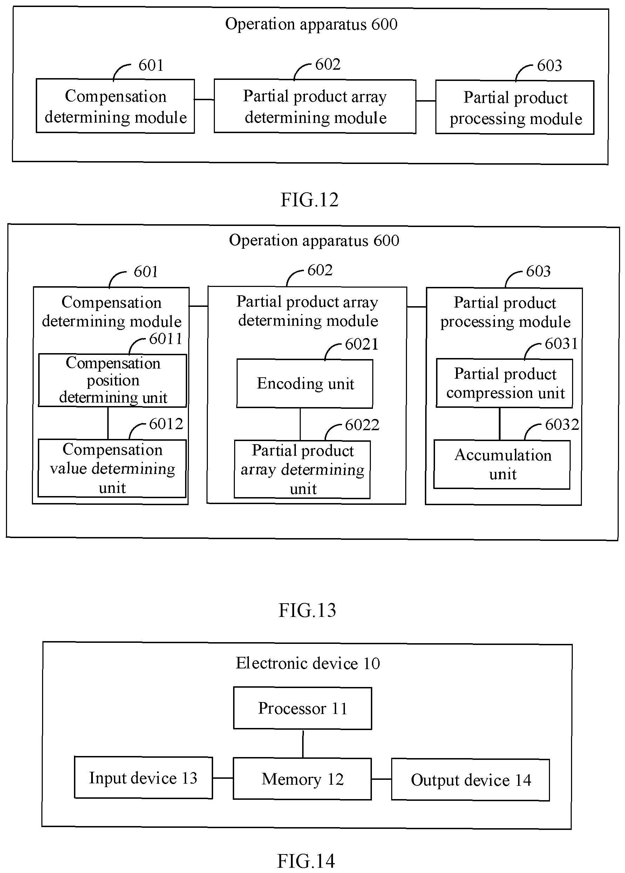

When various functional modules are divided according to corresponding functions, embodiments of this disclosure further provide an operation apparatus. FIG. 12 is a schematic diagram of a structure of an operation apparatus according to an embodiment of this disclosure. The operation apparatus 600 may include a compensation determining module 601, a partial product array determining module 602, and a partial product processing module 603.

The compensation determining module 601 is configured to: determine a plurality of input data sets of a multiplier and an encoding manner for the multiplier; determine at least one low-order input data set in the plurality of input data sets; and determine a carry compensation term corresponding to the at least one low-order input data set based on the at least one low-order input data set and the encoding manner.

The partial product array determining module 602 is configured to determine a target partial product array based on the carry compensation term corresponding to the at least one low-order input data set that is determined by the compensation determining module 601 and the plurality of input data sets.

The partial product processing module 603 is configured to determine a product operation result for each input data set based on the target partial product array determined by the partial product array determining module 602.

In some embodiments, referring to FIG. 12, as shown in FIG. 13, the compensation determining module 601 may include a compensation position determining unit 6011 and a compensation value determining unit 6012. The compensation position determining unit 6011 is configured to determine a compensation position of the carry compensation term corresponding to the at least one low-order input data set based on the encoding manner, a data bit width of the at least one low-order input data set, and a position of the at least one low-order input data set in the plurality of input data sets. The compensation value determining unit 6012 is configured to determine a compensation value of the carry compensation term corresponding to the at least one low-order input data set based on a numerical value of a sign bit of each piece of data in the at least one low-order input data set.

In some embodiments, the compensation position determining unit 6011 is specifically configured to: determine a position of a last row of a sub partial product array corresponding to the at least one low-order input data set based on the encoding manner, the data bit width of the at least one low-order input data set, and the position of the at least one low-order input data set in the plurality of input data sets; and determine the compensation position of the carry compensation term corresponding to the at least one low-order input data set based on the position of the last row of the sub partial product array corresponding to the at least one low-order input data set.

In some embodiments, the compensation value determining unit 6012 is specifically configured to: perform a NXOR operation on numerical values of sign bits of a multiplicator and a multiplicand in each low-order input data set, to determine a numerical value obtained through the NXOR operation; and determine the compensation value of the carry compensation term corresponding to each low-order input data set based on the numerical value obtained through the NXOR operation.

In some embodiments, the compensation value determining unit 6012 is specifically configured to: determine, based on numerical values of sign bits of a multiplicator and a multiplicand in each low-order input data set, a symbol value of a product operation result of the multiplicator and the multiplicand; and perform a negation operation on the symbol value of the product operation result, to obtain the compensation value of the carry compensation term corresponding to each low-order input data set.

In some embodiments, referring to FIG. 12, as shown in FIG. 13, the partial product array determining module 602 includes an encoding unit 6021 and a partial product array determining unit 6022. The encoding unit 6021 is configured to encode each input data set by using an encoding manner corresponding to the data bit width of each input data set, to obtain encoded data corresponding to each input data set. The partial product array determining unit 6022 is configured to: generate an initial partial product array based on the encoded data corresponding to each input data set, where the initial partial product array includes the sub partial product array corresponding to each input data set; and add the carry compensation term into the initial partial product array based on the compensation position and the compensation value of the carry compensation term corresponding to the at least one low-order input data set, to obtain the target partial product array.

In some embodiments, the compensation determining module 601 is specifically configured to: determine the at least one low-order input data set in the plurality of input data sets in response to that a sum of data bit widths of all the input data sets is less than or equal to a maximum data bit width supported by the multiplier.

In some embodiments, referring to FIG. 12, as shown in FIG. 13, the partial product processing module 603 includes a partial product compression unit 6031 and an accumulation unit 6032. The partial product compression unit 6031 is configured to compress the target partial product array by using a Wallace-tree compressor, to obtain compressed data. The accumulation unit 6032 is configured to accumulate the compressed data to obtain the product operation result of each input data set.

For beneficial technical effects corresponding to the exemplary embodiments of this apparatus, reference may be made to the corresponding beneficial technical effects in the part of exemplary method described above, and details are not described herein again.

Exemplary electronic device

FIG. 14 is a schematic diagram of a structure of an electronic device according to an embodiment of this disclosure. The electronic device 10 includes at least one processor 11 and a memory 12.

The processor 11 may be a central processing unit (CPU) or another form of processing unit having a data processing capability and/or an instruction execution capability, and may control another component in the electronic device 10 to perform a desired function.

The memory 12 may include one or more computer program products. The computer program product may include various forms of computer readable storage media, such as a volatile memory and/or a non-volatile memory. The volatile memory may include, for example, a random access memory (RAM) and/or a cache. The nonvolatile memory may include, for example, a read-only memory (ROM), a hard disk, and a flash memory. One or more computer program instructions may be stored on the computer readable storage medium. The processor 11 may execute one or more of the program instructions to implement the operation method of multiplier according to various embodiments of this disclosure that are described above and/or other desired functions.

In an example, the electronic device 10 may further include an input device 13 and an output device 14. These components are connected to each other through a bus system and/or another form of connection mechanism (not shown).

The input device 13 may further include, for example, a keyboard and a mouse.

The output device 14 may output various information to the outside. The output device 14 may include, for example, a display, a speaker, a printer, a communication network, and a remote output device connected by the communication network.

Certainly, for simplicity, FIG. 14 shows only some of components in the electronic device 10 that are related to this disclosure, and components such as a bus and an input/output interface are omitted. In addition, according to specific application situations, the electronic device 10 may further include any other appropriate components.

Exemplary computer program product and computer readable storage medium

In addition to the foregoing methods and devices, the embodiments of this disclosure may also provide a computer program product, which includes computer program instructions. When the computer program instructions are run by a processor, the processor is enabled to perform the steps, of the operation method of multiplier according to the embodiments of this disclosure, that are described in the "exemplary method" part described above.

The computer program product may be program code, written with one or any combination of a plurality of programming languages, that is configured to perform the operations in the embodiments of this disclosure. The programming languages include an object-oriented programming language such as Java or C++, and further include a conventional procedural programming language such as a "C" language or a similar programming language. The program code may be entirely or partially executed on a user computing device, executed as an independent software package, partially executed on the user computing device and partially executed on a remote computing device, or entirely executed on the remote computing device or a server.

In addition, the embodiments of this disclosure may further relate to a computer readable storage medium, which stores computer program instructions. When the computer program instructions are run by a processor, the processor is enabled to perform the steps, of the operation method of multiplier according to the embodiments of this disclosure, that are described in the "exemplary method" part described above.

The computer readable storage medium may be one readable medium or any combination of a plurality of readable media. The readable medium may be a readable signal medium or a readable storage medium. The readable storage medium includes, for example, but is not limited to electricity, magnetism, light, electromagnetism, infrared ray, or a semiconductor system, an apparatus, or a device, or any combination of the above. More specific examples (a non-exhaustive list) of the readable storage medium include: an electrical connection with one or more conducting wires, a portable disk, a hard disk, a random access memory (RAM), a read-only memory (ROM), an erasable programmable read-only memory (EPROM or a flash memory), an optical fiber, a portable compact disk read-only memory (CD-ROM), an optical storage device, a magnetic storage device, or any suitable combination of the above.

Basic principles of this disclosure are described above in combination with specific embodiments. However, advantages, superiorities, and effects mentioned in this disclosure are merely examples but are not for limitation, and it cannot be considered that these advantages, superiorities, and effects are necessary for each embodiment of this disclosure. In addition, specific details described above are merely for examples and for ease of understanding, rather than limitations. The details described above do not limit that this disclosure must be implemented by using the foregoing specific details.

A person skilled in the art may make various modifications and variations to this disclosure without departing from the spirit and the scope of this application. In this way, if these modifications and variations of this application fall within the scope of the claims and equivalent technologies of the claims of this disclosure, this disclosure also intends to include these modifications and variations.

## Claims

1. An operation method of multiplier, **characterized in that** the operation method comprises:

   determining (S101) a plurality of input data sets of the multiplier and an encoding manner for the multiplier;
   determining (S102) at least one low-order input data set in the plurality of input data sets;
   determining (S103) a carry compensation term corresponding to the at least one low-order input data set based on the at least one low-order input data set and the encoding manner;
   determining (S104) a target partial product array based on the carry compensation term corresponding to the at least one low-order input data set and the plurality of input data sets; and
   determining (S105) a product operation result for each input data set based on the target partial product array.

2. The method according to claim 1, wherein the determining (S103) a carry compensation term corresponding to the at least one low-order input data set based on the at least one low-order input data set in the plurality of input data sets and the encoding manner comprises:

   determining (S201) a compensation position of the carry compensation term corresponding to the at least one low-order input data set based on the encoding manner, a data bit width of the at least one low-order input data set, and a position of the at least one low-order input data set in the plurality of input data sets; and
   determining (S202) a compensation value of the carry compensation term corresponding to the at least one low-order input data set based on a numerical value of a sign bit of each piece of data in the at least one low-order input data set.

3. The method according to claim 2, wherein the determining (S201) a compensation position of the carry compensation term corresponding to the at least one low-order input data set based on the encoding manner, a data bit width of the at least one low-order input data set, and a position of the at least one low-order input data set in the plurality of input data sets comprises:

   determining (S301) a position of a last row of a sub partial product array corresponding to the at least one low-order input data set based on the encoding manner, the data bit width of the at least one low-order input data set, and the position of the at least one low-order input data set in the plurality of input data sets; and
   determining (S302) the compensation position of the carry compensation term corresponding to the at least one low-order input data set based on the position of the last row of the sub partial product array corresponding to the at least one low-order input data set.

4. The method according to claim 2, wherein the determining (S202) a compensation value of the carry compensation term corresponding to the at least one low-order input data set based on a numerical value of a sign bit of each piece of data in the at least one low-order input data set comprises:

   performing (S303) a NXOR operation on numerical values of sign bits of a multiplicator and a multiplicand in each low-order input data set, to determine a numerical value obtained through the NXOR operation; and

determining (S304) the compensation value of the carry compensation term corresponding to each low-order input data set based on the numerical value obtained through the NXOR operation.

5. The method according to claim 2, wherein the determining (S202) a compensation value of the carry compensation term corresponding to the at least one low-order input data set based on a numerical value of a sign bit of each piece of data in the at least one low-order input data set comprises:

determining (S401), based on numerical values of sign bits of a multiplicator and a multiplicand in each low-order input data set, a symbol value of a product operation result of the multiplicator and the multiplicand; and performing (S402) a negation operation on the symbol value of the product operation result, to obtain the compensation value of the carry compensation term corresponding to each low-order input data set.

6. The method according to any one of claims 2 to 5, wherein the determining (S104) a target partial product array based on the carry compensation term corresponding to the at least one low-order input data set and the plurality of input data sets comprises:

encoding (S501) each input data set by using an encoding manner corresponding to the data bit width of each input data set, to obtain encoded data corresponding to each input data set; generating (S502) an initial partial product array based on the encoded data corresponding to each input data set, wherein the initial partial product array comprises the sub partial product array corresponding to each input data set; and adding (S503) the carry compensation term into the initial partial product array based on the compensation position and the compensation value of the carry compensation term corresponding to the at least one low-order input data set, to obtain the target partial product array.

7. The method according to any one of claims 1 to 5, wherein the determining (S102) at least one low-order input data set in the plurality of input data sets comprises:
determining the at least one low-order input data set in the plurality of input data sets in response to that a sum of data bit widths of all the input data sets is less than or equal to a maximum data bit width supported by the multiplier.

8. The method according to any one of claims 1 to 5, wherein the determining (S105) a product operation result for each input data set based on the target partial product comprises:

compressing (S504) the target partial product array by using a Wallace-Tree compressor, to obtain compressed data; and accumulating (S505) the compressed data to obtain the product operation result of each input data set.

9. An operation apparatus (600), **characterized in that** the operation apparatus comprises:

a compensation determining module (601), configured to: determine a plurality of input data sets of a multiplier and an encoding manner for the multiplier; determine at least one low-order input data set in the plurality of input data sets; and determine a carry compensation term corresponding to the at least one low-order input data set based on the at least one low-order input data set and the encoding manner; a partial product array determining module (602), configured to determine a target partial product array based on the carry compensation term corresponding to the at least one low-order input data set that is determined by the compensation determining module and the plurality of input data sets; and a partial product processing module (603), configured to determine a product operation result for each input data set based on the target partial product array determined by the partial product array determining module.

10. The operation apparatus (600) according to claim 9, wherein the compensation determining module (601) includes:

a compensation position determining unit (6011), which is configured to determine a compensation position of the carry compensation term corresponding to the at least one low-order input data set based on the encoding manner, a data bit width of the at least one low-order input data set, and a position of the at least one low-order input data set in the plurality of input data set ; and a compensation value determining unit (6012), which is configured to determine a compensation value of the carry compensation term corresponding to the at least one low-order input data set based on a numerical value of a sign bit of each piece of data in the at least one low-order input data set.

**11.** The operation apparatus (600) according to claim 9, wherein the compensation value determining unit (6012) is configured to:

perform a NXOR operation on numerical values of sign bits of a multiplicator and a multiplicand in each low-order input data set, to determine a numerical value obtained through the NXOR operation; and
determine the compensation value of the carry compensation term corresponding to each low-order input data set based on the numerical value obtained through the NXOR operation.

**12.** The operation apparatus (600) according to claim 9, wherein the partial product array determining module (602) includes:

an encoding unit (6021), which is configured to encode each input data set by using an encoding manner corresponding to the data bit width of each input data set, to obtain encoded data corresponding to each input data set; and
a partial product array determining unit (6022), which is configured to: generate an initial partial product array based on the encoded data corresponding to each input data set, wherein the initial partial product array includes the sub partial product array corresponding to each input data set; and add the carry compensation term into the initial partial product array based on the compensation position and the compensation value of the carry compensation term corresponding to the at least one low-order input data set, to obtain the target partial product array.

**13.** The operation apparatus (600) according to claim 9, wherein the partial product processing module (603) includes:

a partial product compression unit (6031), which is configured to compress the target partial product array by using a Wallace-tree compressor, to obtain compressed data; and
an accumulation unit (6032), which is configured to accumulate the compressed data to obtain the product operation result of each input data set.

**14.** A computer readable storage medium, **characterized in that** the storage medium stores a computer program, and the computer program is used for implementing the operation method of multiplier according to any one of claims 1 to 8 when executed by a processor.

**15.** An electronic device (10), **characterized in that** the electronic device comprises:

a processor (11); and
a memory (12), configured to store processor-executable instructions,
wherein the processor (11) is configured to read the executable instructions from the memory (12), and execute the executable instruction to implement the operation method of multiplier according to any one of claims 1 to 8.

| Determine a plurality of input data sets of a multiplier and an encoding manner for the multiplier | S101 |

| Determine at least one low-order input data set in the plurality of input data sets | S102 |

| Determine a carry compensation term corresponding to the at least one low-order input data set based on the at least one low-order input data set and the encoding manner | S103 |

| Determine a target partial product array based on the carry compensation term corresponding to the at least one low-order input data set and the plurality of input data sets | S104 |

| Determine a product operation result for each input data set based on the target partial product array | S105 |

FIG.1

FIG.2

FIG.3

Determine a plurality of input data sets of a multiplier and an encoding manner for the multiplier ⟋ S101

Determine at least one low-order input data set in the plurality of input data sets ⟋ S102

⟋ S103

Determine a compensation position of a carry compensation term corresponding to the at least one low-order input data set based on the encoding manner, a data bit width of the at least one low-order input data set, and a position of the at least one low-order input data set in the plurality of input data sets ⟋ S201

Determine a compensation value of the carry compensation term corresponding to the at least one low-order input data set based on a numerical value of a sign bit of each piece of data in the at least one low-order input data set ⟋ S202

Determine a target partial product array based on the carry compensation term corresponding to the at least one low-order input data set and the plurality of input data sets ⟋ S104

Determine a product operation result for each input data set based on the target partial product array ⟋ S105

FIG.4

Determine a plurality of input data sets of a multiplier and an encoding manner for the multiplier ⌐ S101

Determine at least one low-order input data set in the plurality of input data sets ⌐ S102

⌐ S103

Determine a position of a last row of a sub partial product array corresponding to the at least one low-order input data set based on the encoding manner, a data bit width of the at least one low-order input data set, and a position of the at least one low-order input data set in the plurality of input data sets ⌐ S201 / S301

Determine a compensation position of a carry compensation term corresponding to the at least one low-order input data set based on the position of the last row of the sub partial product array corresponding to the at least one low-order input data set ⌐ S302

Perform a NXOR operation on numerical values of sign bits of a multiplicator and a multiplicand in each low-order input data set, to determine a numerical value obtained through the NXOR operation ⌐ S202 / S303

Determine a compensation value of the carry compensation term corresponding to the at least one low-order input data set based on the numerical value obtained through the NXOR operation ⌐ S304

Determine a target partial product array based on the carry compensation term corresponding to the at least one low-order input data set and the plurality of input data sets ⌐ S104

Determine a product operation result for each input data set based on the target partial product array ⌐ S105

FIG.5

| | |
|---|---|
| Determine a plurality of input data sets of a multiplier and an encoding manner for the multiplier | S101 |

| | |
|---|---|
| Determine at least one low-order input data set in the plurality of input data sets | S102 |

S103

S201

| | |
|---|---|
| Determine a position of a last row of a sub partial product array corresponding to the at least one low-order input data set based on the encoding manner, a data bit width of the at least one low-order input data set, and a position of the at least one low-order input data set in the plurality of input data sets | S301 |

| | |
|---|---|
| Determine a compensation position of a carry compensation term corresponding to the at least one low-order input data set based on the position of the last row of the sub partial product array corresponding to the at least one low-order input data set | S302 |

S202

| | |
|---|---|
| Determine, based on numerical values of sign bits of a multiplicator and a multiplicand in each low-order input data set, a symbol value of a product operation result of the multiplicator and the multiplicand | S401 |

| | |
|---|---|
| Perform a negation operation on the symbol value of the product operation result, to obtain a compensation value of the carry compensation term corresponding to each low-order input data set | S402 |

| | |
|---|---|
| Determine a target partial product array based on the carry compensation term corresponding to the at least one low-order input data set and the plurality of input data sets | S104 |

| | |
|---|---|
| Determine a product operation result for each input data set based on the target partial product array | S105 |

FIG.6

Determine a plurality of input data sets of a multiplier and an encoding manner for the multiplier —— S101

Determine at least one low-order input data set in the plurality of input data sets —— S102

—— S103

Determine a compensation position of a carry compensation term corresponding to the at least one low-order input data set based on the encoding manner, a data bit width of the at least one low-order input data set, and a position of the at least one low-order input data set in the plurality of input data sets —— S201

Determine a compensation value of the carry compensation term corresponding to the at least one low-order input data set based on a numerical value of a sign bit of each piece of data in the at least one low-order input data set —— S202

—— S104

Encode each input data set by using an encoding manner corresponding to a data bit width of each input data set, to obtain encoded data corresponding to each input data set —— S501

Generate an initial partial product array based on the encoded data corresponding to each input data set, wherein the initial partial product array includes a sub partial product array corresponding to each input data set —— S502

Add the carry compensation term into the initial partial product array based on the compensation position and the compensation value of the carry compensation term corresponding to the at least one low-order input data set, to obtain a target partial product array —— S503

—— S105

Compress the target partial product array by using a Wallace-Tree compressor, to obtain compressed data —— S504

Accumulate the compressed data to obtain a product operation result of each input data set —— S505

FIG.7

Electronic device    First multiplicator $A_N$ and first
multiplicand $B_N$ (including: an $n_1$-bit first
input data set, an $n_2$-bit second input data
set, ..., and an $n_m$-bit $m^{th}$ input data set)

Input signal dxlp

Multiplier with a data bit width of N

Target PPA

PPA$_1$

PPA$_2$

...

PPA$_m$

Wallace-Tree compressor

Summator

Accumulation result (including: a product
operation result of the first input data set, a
product operation result of the second input data
set, ..., and a product operation result of the $m^{th}$
input data set)

FIG.8

FIG.9

Second input data set | First input data set

First multiplicand B16=0000 0010 1000 1010:
$B_{8-2}$=0000 0010, 2 | $B_{8-1}$=1000 1010, -118

First multiplicator A16=0010 1011 0011 0001:
$A_{8-2}$=0010 1011, 43 | $A_{8-1}$=0011 0001, 49

Perform 8-bit radix-4 booth encoding on $A_{8-1}$ and $A_{8-2}$, respectively

Encoded data corresponding to the second input data set

Sign bit $S_1$ of $A_{8-2}$ on which booth encoding is performed | Sign bit $e_1$ of a product term | Auxiliary bit

0 0 1 0 1 0 1 1 0

$B_{8-2}$  $-B_{8-2}$  $-B_{8-2}$  $-B_{8-2}$

| 1 | 0 | 1 1 1 1 1 1 0 1 |
| 1 | 0 | 1 1 1 1 1 1 0 1 |
| 1 | 0 | 1 1 1 1 1 1 0 1 |
| 0 | 1 | 0 0 0 0 0 0 1 0 |

Encoded data corresponding to the first input data set

Auxiliary bit

0 0 1 1 0 0 0 1 0

$B_{8-1}$  $-B_{8-1}$  0  $B_{8-1}$  | Sign bit $S_0$ of $A_{8-1}$ on which booth encoding is performed | Sign bit $e_0$ of a product term

| 1 1 0 0 0 1 0 1 0 | 0 | 0 |
| 0 0 0 0 0 0 0 0 0 | 0 | 1 |
| 0 0 1 1 1 0 1 0 1 | 1 | 1 |
| 1 1 0 0 0 1 0 1 0 | 0 | 0 |

Generate a target PPA

Target PPA

PPA1
$e_0$  $\overline{e_0}$
0 1 1 1 1 0 0 0 1 0 1 0
$e_0$  0 1 1 1 1 0 0 0 1 0 1 0  $s_0$
$e_0$  1 1 0 0 0 0 0 0 0 0 0 0  $s_0$
1 1 0 0 1 1 1 0 1 0 1 0  $s_0$
$e_0$  0 1 1 0 0 0 1 0 1 0 1 1  $s_0$
0  $s_0$

Carry compensation term $E_1$
$\overline{e_1}$
0 0 0 0 0 0 0 0 0 0 0 0 0 0 0 0

PPA2
$e_1$ $e_1$  0 1 1 1 1 1 1 1 1 1 0 1
$e_1$  1 0 1 1 1 1 1 1 1 0 1 1  $s_1$
$e_1$  1 0 1 1 1 1 1 1 0 1 1  $s_1$
$e_1$  1 0 0 0 0 0 0 0 1 0 1  $s_1$
0  $s_1$

0 0 0 0 0 0 0 0 0 1 0 1 0 1 1 0  1 1 1 0 1 0 0 1 0 1 1 0 1 0 1 0

Product operation result of each input data set

$C_2$=0000 0000 0101 0110, 86 | $C_1$=1110 1001 0110 1010, -5728

FIG.10

First multiplicand B16=0110 1101 0010 1000:

First multiplicator A₁₆=1000 1010 0011 0000:

**Second input data set**

$B_{8-2}$=0110 1101, 109

$A_{8-2}$=1000 1010, -118

**First input data set**

$B_{8-1}$=0010 1000, 40

$A_{8-1}$=0011 0000, 48

Perform 8-bit radix-4 booth encoding on $A_{8-1}$ and $A_{8-2}$, respectively

**Encoded data corresponding to the second input data set**

Sign bit $S_1$ of $A_{8-2}$ on which booth encoding is performed | Sign bit $e_1$ of a product term | Auxiliary bit
1 0 0 0 1 0 1 0 0 | −2$B_{8-2}$  $B_{8-2}$  −$B_{8-2}$  −2$B_{8-2}$

| 1 | 0 | 1 0 0 1 0 0 1 0 1 |
| 1 | 0 | 1 1 0 0 1 0 0 1 0 |
| 0 | 1 | 0 0 1 1 0 1 1 0 1 |
| 1 | 0 | 1 0 0 1 0 0 1 0 1 |

**Encoded data corresponding to the first input data set**

0 0 1 1 0 0 0 0 0 | Auxiliary bit
$B_{8-1}$  −$B_{8-1}$  0  0 | Sign bit $S_0$ of $A_{8-1}$ on which booth encoding is performed | Sign bit $e_0$ of a product term

| 0 0 0 0 0 0 0 0 0 | 0 | 1 |
| 0 0 0 0 0 0 0 0 0 | 0 | 1 |
| 1 1 1 0 1 0 1 1 1 | 1 | 0 |
| 0 0 0 1 0 1 0 0 0 | 0 | 1 |

Generate a target PPA

**Target PPA**

$PPA_1$, $PPA_2$, Carry compensation term $E_1$, $e_1$, $e_0$, $s_0$, $s_1$ ...

1 1 0 0 1 1 0 1 1 1 0 0 0 0 1 0   0 0 0 0 0 1 1 1 1 0 0 0 0 0 0 0

Product operation result of each input data set

$C_2$=1100 1101 1100 0010, -12862

$C_1$=0000 0111 1000 0000, 1920

**FIG.11**

Operation apparatus 600

| Compensation determining module | Partial product array determining module | Partial product processing module |
|---|---|---|

601 — 602 — 603

FIG.12

Operation apparatus 600

601

Compensation determining module

6011

Compensation position determining unit

6012

Compensation value determining unit

602

Partial product array determining module

6021

Encoding unit

6022

Partial product array determining unit

603

Partial product processing module

6031

Partial product compression unit

6032

Accumulation unit

FIG.13

Electronic device 10

Processor 11

| Input device 13 | Memory 12 | Output device 14 |
|---|---|---|

FIG.14

## EUROPEAN SEARCH REPORT

Europäisches
Patentamt
European
Patent Office
Office européen
des brevets

**Application Number**

EP 24 16 4815

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/225705 A1 (RUMYNIN DMITRIY [GB]) 11 November 2004 (2004-11-11) * paragraph [0008] - paragraph [0045]; figures 1,6 * | 1-15 | INV. G06F7/533 G06F7/544 |
| A | US 2013/332501 A1 (BOERSMA MAARTEN J [DE] ET AL) 12 December 2013 (2013-12-12) * paragraph [0015] - paragraph [0038] * | 1-15 | |
| A | US 2005/102344 A1 (BERKEMAN ANDERS [SE]) 12 May 2005 (2005-05-12) * paragraph [0056] - paragraph [0063] * | 1-15 | |

TECHNICAL FIELDS
SEARCHED        (IPC)

G06F

The present search report has been drawn up for all claims

| Place of search | Date of completion of the search | Examiner |
|---|---|---|
| Munich | 28 August 2024 | Tenbieg, Christoph |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 4815

This annex lists the patent family members relating to the patent documents cited in the above-mentioned European search report.
The members are as contained in the European Patent Office EDP file on
The European Patent Office is in no way liable for these particulars which are merely given for the purpose of information.

28-08-2024

| Patent document cited in search report | Publication date | Patent family member(s) | Publication date |
|---|---|---|---|
| US 2004225705 A1 | 11-11-2004 | GB 2399909 A<br>US 2004225705 A1 | 29-09-2004<br>11-11-2004 |
| US 2013332501 A1 | 12-12-2013 | US 2013332501 A1<br>US 2014095568 A1 | 12-12-2013<br>03-04-2014 |
| US 2005102344 A1 | 12-05-2005 | US 2005102344 A1<br>WO 2005045662 A1 | 12-05-2005<br>19-05-2005 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310468468